# EUROPÄISCHE PATENTSCHRIFT

(11) **EP 3 979 436 B1**
(45) Veröffentlichungstag und Bekanntmachung des Hinweises auf die Patenterteilung: **08.05.2024**
(21) Anmeldenummer: 20199668.3
(22) Anmeldetag: 01.10.2020
(51) Int. Cl.: H01R 24/50, H01R 24/52, H01R 25/00, H01R 31/06, H01R 31/00

(54) **ELEKTRISCHER STECKVERBINDER, LEITERPLATTENANORDNUNG UND VERFAHREN ZUR MONTAGE EINER LEITERPLATTENANORDNUNG**
ELECTRICAL CONNECTOR, CIRCUIT BOARD ASSEMBLY AND METHOD FOR MOUNTING A CIRCUIT BOARD ASSEMBLY
CONNECTEUR ENFICHABLE ÉLECTRIQUE, AGENCEMENT DE CARTE DE CIRCUIT IMPRIMÉ ET PROCÉDÉ DE MONTAGE D'UN AGENCEMENT DE CARTE DE CIRCUIT IMPRIMÉ

(43) Veröffentlichungstag der Anmeldung: 06.04.2022
(73) Patentinhaber: ROSENBERGER HOCHFREQUENZTECHNIK GMBH & CO. KG, 83413 Fridolfing (DE)
(72) Erfinder: Wild, Werner, 86647 Buttenwiesen (DE); Heubeck, Johannes, 83413 Fridolfing (DE); Stadler, Tobias, 83413 Fridolfing (DE); Gruber, Andreas, 83404 Ainring (DE)
(74) Vertreter: Lorenz, Markus

(56) Entgegenhaltungen:
- WO-A1-2004/012306
- WO-A1-2013/181146
- JP-A- 2014 130 843
- US-A- 6 065 976
- US-B1- 6 835 093

## Beschreibung

Die Erfindung betrifft einen elektrischen Steckverbinder mit einem ersten Endabschnitt, an dem eine erste Schnittstelle angeordnet ist und mit einem zweiten Endabschnitt, an dem eine zweite Schnittstelle angeordnet ist, wobei die erste Schnittstelle und die zweite Schnittstelle jeweils mit einem elektrischen Gegensteckverbinder verbindbar sind, und wobei die erste Schnittstelle mit der zweiten Schnittstelle wenigstens zwei Kontaktelementpaare ausbildet.

Die Erfindung betrifft ferner eine Leiterplattenanordnung, aufweisend einen elektrischen Steckverbinder und eine elektrische Leiterplatte, wobei der Steckverbinder in einer Ausnehmung innerhalb der Leiterplatte aufgenommen ist.

Die Erfindung betrifft außerdem ein Verfahren zur Montage einer Leiterplattenanordnung, wonach ein elektrischer Steckverbinder durch eine Ausnehmung in einer elektrischen Leiterplatte hindurchgeführt und an der Leiterplatte befestigt wird.

Elektronische Systeme verfügen in der Regel über elektronische Schaltungen, die auf Leiterplatten ("Printed Circuit Boards", PCBs) durch Verschaltung mehrerer elektronischer Bauelemente implementiert sind. Häufig sind mehrere Leiterplatten innerhalb eines gemeinsamen elektronischen Systems vorgesehen, um die Schaltungen beispielsweise räumlich in einem Gehäuse zu verteilen oder um unterschiedliche Module eines modularen Systems miteinander zu verbinden. In der Regel ist bei diesem Aufbau eine elektrische Verbindung zwischen den verschiedenen Leiterplatten für einen Signal- und/oder Energieaustausch erforderlich.

Um zwei Leiterplatten elektrisch miteinander zu verbinden, werden häufig Leiterplattensteckverbinder verwendet, die mit der jeweiligen Leiterplatte elektrisch und mechanisch verbunden sind. Zwischen den beiden Leiterplattensteckverbindern kann dann ein Verbindungselement eingesetzt werden, um die Leiterplattensteckverbinder zur Signal- und/oder Energieübertragung miteinander zu verbinden. Derartige Verbindungselemente zur Verbindung der Leiterplattensteckverbinder sind auch unter den Begriffen "Adapter" oder "Bullet" bekannt. Bei dem nachfolgend im Rahmen der Erfindung genannten Gegensteckverbinder kann es sich vorzugsweise um ein derartiges Verbindungselement handeln.

Aus Gründen der Modularität der Leiterplatte und der Flexibilität der Leiterplatten im Rahmen der Montage eines elektronischen Systems kann es von Vorteil sein, wenn die Leiterplatten beidseitig zur Kontaktierung mit dem Verbindungselement verwendbar sind. Somit kann sich die Leiterplatte mit einer oberhalb und/oder unterhalb der Leiterplatte befindlichen weiteren Leiterplatte elektrisch verbinden lassen. Neben der flexibleren Montage kann auch die Herstellbarkeit einer derartigen Leiterplatte wirtschaftlicher sein, da nur noch eine einzige Variante der Leiterplatte bereitgestellt werden muss - unabhängig von der spezifischen Einbausituation.

Zum technischen Hintergrund sei außerdem noch auf die folgenden Druckschriften verwiesen. Die US 6,065,976 A betrifft einen Koaxialsteckverbinder, der eine koaxiale Schnittstelle zum seitlichen Verbinden mit einer Leiterplatte, und zweite weitere koaxiale Schnittstellen zum Verbinden mit einem jeweiligen koaxialen Gegensteckverbinder umfasst. Die WO 2004/012306 A1 betrifft einen Koaxialsteckverbinder zum Verbinden von Koaxialkabeln, mit einer Wandung zwischen den beiden Schnittstellen des Koaxialsteckverbinders.

In Anbetracht des bekannten Stands der Technik besteht die Aufgabe der vorliegenden Erfindung somit darin, einen elektrischen Steckverbinder bereitzustellen, der sich vorzugsweise als beidseitig zugänglicher Leiterplattensteckverbinder vorteilhaft einsetzen lässt.

Schließlich ist es auch Aufgabe der Erfindung, eine flexibel verwendbare Leiterplattenanordnung bereitzustellen.

Außerdem ist es Aufgabe der Erfindung, ein vorteilhaftes Verfahren zur Montage einer Leiterplattenanordnung bereitzustellen.

Die Aufgabe wird für den elektrischen Steckverbinder mit den in Anspruch 1 aufgeführten Merkmalen gelöst. Hinsichtlich der Leiterplattenanordnung wird die Aufgabe durch die Merkmale des Anspruchs 14 gelöst. Betreffend das Verfahren zur Montage einer Leiterplattenanordnung wird die Aufgabe durch Anspruch 15 gelöst.

Die abhängigen Ansprüche und die nachfolgend beschriebenen Merkmale betreffen vorteilhafte Ausführungsformen und Varianten der Erfindung.

Es ist ein elektrischer Steckverbinder vorgesehen, aufweisend einen ersten Endabschnitt, an dem eine erste Schnittstelle angeordnet ist und einen zweiten Endabschnitt, an dem eine zweite Schnittstelle angeordnet ist.

Ein "Endabschnitt" im Sinne der Erfindung erstreckt sich vorzugsweise ausgehend von dem korrespondierenden Ende des Steckverbinders entlang eines definierten Abschnitts entlang der Längsachse des Steckverbinders.

Vorzugsweise umfasst der erste Endabschnitt die erste Schnittstelle ausgehend von dem ersten Ende des Steckverbinders vollständig und der zweite Endabschnitt die zweite Schnittstelle ausgehend von dem zweiten Ende des Steckverbinders vollständig. Die erste Schnittstelle und/oder die zweite Schnittstelle können allerdings auch zu dem jeweiligen Ende des Steckverbinders axial versetzt angeordnet sein - die Schnittstellen müssen demnach nicht zwingend unmittelbar an dem Ende des Steckverbinders angeordnet sein.

Vorzugsweise entspricht die axiale Länge des Endabschnitts der axialen Länge der korrespondierenden Schnittstelle. Die Schnittstelle kann allerdings auch länger sein als der ihr zugeordnete Endabschnitt. Alternativ kann die Schnittstelle auch kürzer sein als der ihr zugeordnete Endabschnitt.

Die erste Schnittstelle und die zweite Schnittstelle sind jeweils mit einem elektrischen Gegensteckverbinder verbindbar.

Die Schnittstellen können insbesondere jeweilige Steckplätze für die Gegensteckverbinder ausbilden (zum ein- und/oder aufstecken des jeweiligen Gegensteckverbinders).

Bei dem Gegensteckverbinder kann es sich vorzugsweise um ein Verbindungselement zur Verbindung zweier elektrischer Leiterplatten handeln (auch unter den Begriffen "Adapter" oder "Bullet" bekannt). Insbesondere kann hierzu ein starres Verbindungselement, vorgesehen sein, beispielsweise ein Verbindungselement mit einem starren Au-ßengehäuse oder einem starren Außenleiter, vorzugsweise aus einem Metall. Bei einem Gegensteckverbinder kann es sich allerdings auch um einen Kabelsteckverbinder handeln, der an einem Ende eines elektrischen Kabels angeordnet ist.

Der Gegensteckverbinder kann einen oder mehrere elektrische Leiter aufweisen, insbesondere einen Außenleiter und einen oder mehrere Innenleiter. Der Innenleiter oder die Innenleiter können von dem Außenleiter durch einen Isolator beabstandet sein. Grundsätzlich kann ein beliebiger Gegensteckverbinder vorgesehen sein. Besonders bevorzugt ist der Gegensteckverbinder als koaxialer Gegensteckverbinder ausgebildet.

Der Gegensteckverbinder kann insbesondere zwei sich gegenüberliegende Endabschnitte mit jeweiligen Kontaktschnittstellen aufweisen, wobei die Kontaktschnittstellen vorzugsweise identischen Typs sind. Die Kontaktschnittstellen können insbesondere Gegensteckplätze für die Steckplätze bzw. Schnittstellen des Steckverbinders ausbilden.

Erfindungsgemäß ist vorgesehen, dass die erste Schnittstelle des Steckverbinders mit dessen zweiter Schnittstelle wenigstens zwei Kontaktelementpaare ausbildet. Jedes der Kontaktelementpaare weist ein erstes Kontaktelement und ein zweites Kontaktelement auf. Das erste Kontaktelement ist der ersten Schnittstelle und das zweite Kontaktelement der zweiten Schnittstelle zugeordnet. Das ersten Kontaktelement ist mechanisch mit dem zweiten Kontaktelement verbunden.

Zwischen den beiden Schnittstellen kann über die miteinander verbundenen Kontaktelemente eines jeweiligen Kontaktelementpaares somit eine elektrische Verbindung bestehen.

Erfindungsgemäß weist der elektrische Steckverbinder zwischen dem ersten Endabschnitt und dem zweite Endabschnitt eine nicht-koaxiale, dritte Schnittstelle auf, um zumindest eines der Kontaktelementpaare elektrisch und mechanisch mit einer elektrischen Leiterplatte zu verbinden.

Der elektrische Steckverbinder kann aus diesem Grunde auch als "Leiterplattensteckverbinder" bezeichnet werden.

Der vorgeschlagene elektrische Steckverbinder weist auf vorteilhafte Weise an seinen Endabschnitten bzw. Enden jeweils einen Steckplatz bzw. jeweils eine Schnittstelle auf, in die ein Gegensteckverbinder, vorzugsweise ein Verbindungselement zur Verbindung des Steckverbinders mit einem Steckverbinder einer zweiten Leiterplatte, einsteckbar ist.

Die Kontaktelemente eines gemeinsamen Kontaktelementpaares können zwischen der ersten Schnittstelle und der zweiten Schnittstelle elektrisch und mechanisch miteinander verbunden und außerdem über die dritte Schnittstelle mit der Leiterplatte elektrisch und mechanisch verbunden sein.

Es ist ein besonderer Vorteil der Erfindung, dass ein Gegensteckverbinder ausgehend von einem beliebigen Ende des Steckverbinders (optional auch gleichzeitig von beiden Enden), vorzugsweise ausgehend von zwei sich gegenüberliegenden Seiten der Leiterplatte, mit dem elektrischen Steckverbinder verbunden werden kann.

Vorzugsweise ist die erste Schnittstelle auf einer ersten Seite der elektrischen Leiterplatte angeordnet und die zweite Schnittstelle auf einer zweiten, der ersten Seite gegenüberliegenden Seite der Leiterplatte angeordnet.

Auf diese Weise kann die Leiterplatte wahlweise mit einer oberhalb und/oder unterhalb der Leiterplatte angeordneten, weiteren Leiterplatte elektrisch verbindbar sein. Der elektrische Steckverbinder und die mit dem Steckverbinder bestückte Leiterplatte sind somit besonders modular und flexibel einsetzbar und außerdem wirtschaftlich herstell- und montierbar.

Vorzugsweise erstreckt sich der elektrische Steckverbinder durch eine Ausnehmung der elektrischen Leiterplatte, besonders bevorzugt in einem zwischen dem ersten Endabschnitt und dem zweiten Endabschnitt angeordneten mittleren Abschnitt. Ein mittlerer Abschnitt kann gegebenenfalls aber auch entfallen - die beiden Endabschnitte oder deren Schnittstellen können auch unmittelbar ineinander übergehen.

Besonders bevorzugt ist der elektrische Steckverbinder in der Ausnehmung der Leiterplatte oder angrenzend an die Ausnehmung der Leiterplatte mechanisch fixiert. Dies kann beispielsweise durch eine Presspassung oder durch eine stoffschlüssige Verbindung, beispielsweise eine Klebeverbindung oder eine Lötverbindung, erfolgen. Grundsätzlich kann eine beliebige form-, kraft- und/oder stoffschlüssige Fixierung vorgesehen sein.

Die Kontaktelemente eines gemeinsamen Kontaktelementpaares können vorzugsweise über eine gemeinsame elektrische Leitung der dritten Schnittstelle mit ihnen zugeordneten elektrischen Leiterbahnen der Leiterplatte verbunden sein.

Es kann vorgesehen sein, dass der elektrische Steckverbinder ausgebildet ist, um ein gleichzeitiges Einstecken von zwei Gegensteckverbindern zu ermöglichen (also einen Zustand mit zwei vollständig gesteckten Gegensteckverbindern an jedem Endabschnitt). Der elektrische Steckverbinder kann in diesem Fall vorteilhaft eine Splitter- oder Combiner-Funktion erfüllen.

Alternativ kann - je nach Anwendungsfall - aber auch vorgesehen sein, dass der elektrische Steckverbinder ausgebildet ist, um ausschließlich das Einstecken eines einzigen Gegensteckverbinders wahlweise in die erste Schnittstelle oder in die zweite Schnittstelle zu ermöglichen. Beispielsweise können die Kontaktelementpaare und/oder das nachfolgend noch beschriebene Isolierelement entsprechend ausgebildet und dimensioniert sein, um ein beidseitiges Stecken von Gegensteckverbindern formschlüssig zu blockieren. Dies kann beispielsweise dadurch erfolgen, dass ein vollständig gesteckter Gegensteckverbinder mit seinem Ende in die gegenüberliegende Schnittstelle hineinragt und damit einem weiteren Gegensteckverbinder den Einsteckweg (zumindest teilweise) versperrt.

Vorzugsweise ist der elektrische Steckverbinder entlang seiner Längsachse mittig mit der elektrischen Leiterplatte verbunden, insbesondere in der Ausnehmung der Leiterplatte aufgenommen. Die axialen Längen des ersten Endabschnitts und des zweiten Endabschnitts und/oder der ersten Schnittstelle und der zweiten Schnittstelle sind vorzugsweise identisch.

Gemäß einer bevorzugten Weiterbildung der Erfindung kann vorgesehen sein, dass der elektrische Steckverbinder einen linearen bzw. geradlinigen Verlauf zwischen dem ersten Endabschnitt / ersten Ende und dem zweiten Endabschnitt / zweiten Ende aufweist.

Vorzugsweise verläuft die Mittelachse des elektrischen Steckverbinders ausgehend von dem ersten Ende des Steckverbinders bis zu dem zweiten Ende des Steckverbinders geradlinig bzw. linear.

Es kann allerdings auch ein winkliger, beispielsweise stufiger Verlauf zwischen dem ersten Endabschnitt / ersten Ende und dem zweiten Endabschnitt / zweiten Ende vorgesehen sein. Beispielsweise kann der Steckverbinder im Bereich der ersten Schnittstelle und/oder im Bereich der zweiten Schnittstelle winklig in der Art eines Winkelsteckverbinders ausgebildet sein.

Ein linearer bzw. geradliniger Verlauf ist allerdings bevorzugt, da sich der elektrische Steckverbinder dann vorteilhaft zur Herstellung einer elektrischen Verbindung zwischen parallel - oder zumindest im Wesentlichen parallel - zueinander angeordneten elektrischen Leiterplatten eignen kann.

In einer vorteilhaften Weiterbildung der Erfindung kann vorgesehen sein, dass die erste Schnittstelle und die zweite Schnittstelle jeweils mit einem elektrischen Gegensteckverbinder identischen Steckverbindertyps verbindbar sind.

Die beiden Steckplätze bzw. die erste Schnittstelle und die zweite Schnittstelle weisen bevorzugt ein identisches mechanisches und elektrisches Interface auf. Die erste Schnittstelle und die zweite Schnittstelle können somit einen identischen bzw. zumindest funktional identischen Aufbau aufweisen.

Grundsätzlich kann auch vorgesehen sein, dass die erste Schnittstelle und die zweite Schnittstelle jeweils mit einem elektrischen Gegensteckverbinder verschiedenen Steckverbindertyps verbindbar sind. Die erste Schnittstelle und die zweite Schnittstelle können damit gegebenenfalls auch unterschiedliche Steckverbindernormen realisieren. Diese Variante der Erfindung ist allerdings nicht unbedingt bevorzugt.

Gemäß einer Weiterbildung der Erfindung kann vorgesehen sein, dass eines der Kontaktelementpaare als Außenleiterkontaktelementpaar mit einem ersten Außenleiterkontaktelement und mit einem zweiten Außenleiterkontaktelement ausgebildet ist.

Das erste Außenleiterkontaktelement und/oder das zweite Außenleiterkontaktelement kann vorzugsweise hülsenförmig ausgebildet sein, beispielsweise in der Art eines Rohrs.

Das erste Außenleiterkontaktelement und/oder das zweite Außenleiterkontaktelement kann entlang des Umfangs vorzugsweise vollständig oder zumindest im Wesentlichen vollständig geschlossen sein, um eine möglichst vollumfängliche elektromagnetische Abschirmung und eine hohe mechanische Stabilität bereitzustellen. Es kann grundsätzlich aber auch eine Ausgestaltung als Federkorb vorgesehen sein.

Das erste Außenleiterkontaktelement und/oder das zweite Außenleiterkontaktelement kann optional eine oder mehrere Federlaschen zur Kontaktierung eine Außenleiters des Gegensteckverbinders aufweisen.

Das erste Außenleiterkontaktelement und/oder das zweite Außenleiterkontaktelement kann vorzugsweise vollständig oder zumindest teilweise aus einem Metall oder einer Metalllegierung ausgebildet sein. Das erste Außenleiterkontaktelement und/oder das zweite Außenleiterkontaktelement kann insbesondere als Stanz-Biegeteil, Drehteil oder tiefgezogenes Bauteil ausgebildet sein.

Grundsätzlich ist die Verwendung eines Außenleiterkontaktelementpaares nicht unbedingt erforderlich. Der elektrische Steckverbinder kann auch ungeschirmt ausgebildet sein.

Gemäß einer Weiterbildung der Erfindung kann vorgesehen sein, dass eines oder mehrere weitere Kontaktelementpaare als Innenleiterkontaktelementpaar(e) mit einem jeweiligen ersten Innenleiterkontaktelement und mit einem jeweiligen zweiten Innenleiterkontaktelement ausgebildet sind.

Vorzugsweise weist der elektrische Steckverbinder genau ein Innenleiterkontaktelementpaar auf, das innerhalb genau eines Außenleiterkontaktelementpaares verläuft.

Der elektrische Steckverbinder kann grundsätzlich aber beliebig ausgebildet sein, und kann insbesondere mehrere Innenleiterkontaktelementpaare aufweisen, beispielsweise zwei, drei, vier, fünf, sechs oder noch mehr Innenleiterkontaktelementpaare. Die Innenleiterkontaktelementpaare können innerhalb eines gemeinsamen Außenleiterkontaktelementpaares oder verteilt auf mehrere Außenleiterkontaktelementpaare angeordnet sein (insofern mehrere Außenleiterkontaktelemente vorgesehen sind).

Gemäß einer Weiterbildung der Erfindung kann vorgesehen sein, dass die Längsachsen der beiden Außenleiterkontaktelemente des Außenleiterkontaktelementpaares koaxial verlaufen. Es kann außerdem vorgesehen sein, dass die Längsachsen der Innenleiterkontaktelemente eines jeweiligen Innenleiterkontaktelementpaares koaxial verlaufen.

Die Längsachsen können vorzugsweise einen linearen Verlauf ausbilden, können grundsätzlich aber auch winklige Abschnitte aufweisen.

In einer Weiterbildung der Erfindung kann vorgesehen sein, dass genau ein Innenleiterkontaktelementpaar koaxial innerhalb des Außenleiterkontaktelementpaares angeordnet ist.

Grundsätzlich kann eine beliebige Anzahl Außenleiterkontaktelementpaare und Innenleiterkontaktelementpaare mit vorzugsweise koaxialer Ausrichtung vorgesehen sein. Beispielsweise kann der elektrische Steckverbinder auch in der Art eines Triaxialsteckverbinders ausgebildet sein.

Der elektrische Steckverbinder muss allerdings nicht unbedingt koaxial ausgebildet sein.

In einer Weiterbildung der Erfindung kann vorgesehen sein, dass die Innenleiterkontaktelemente als Stiftkontakte oder als Buchsenkontakte ausgebildet sind.

Die Innenleiterkontaktelemente (Stiftkontakte oder Buchsenkontakte) können Federlaschen aufweisen, beispielsweise einseitig oder beidseitig angebundene Federlaschen, um die Kontaktierung mit einem korrespondierenden Leiter des Gegensteckverbinders zu ermöglichen oder zu verbessern. Die Verwendung von Federlaschen ist allerdings nicht unbedingt erforderlich, insbesondere dann nicht, wenn der korrespondierende Leiter des Gegensteckverbinders Federlaschen aufweist.

In einer vorteilhaften Weiterbildung der Erfindung kann vorgesehen sein, dass die beiden Kontaktelemente eines gemeinsamen Kontaktelementpaares einteilig oder zweiteilig ausgebildet sind.

Vorzugsweise sind die Innenleiterkontaktelemente eines gemeinsamen Innenleiterkontaktelementpaares einteilig ausgebildet. Auch ein mehrteiliger Aufbau der Innenleiterkontaktelemente kann allerdings vorgesehen sein.

Vorzugsweise sind die Außenleiterkontaktelemente eines gemeinsamen Außenleiterkontaktelementpaares mehrteilig ausgebildet, um die Montage auf der elektrischen Leiterplatte zu vereinfachen. Auch eine einteilige Ausgestaltung der Außenleiterkontaktelemente kann allerdings vorgesehen sein.

Bei Verwendung eines mehrteiligen Außenleiterkontaktelementpaares kann vorgesehen sein, dass die Außenleiterkontaktelemente unter Verwendung des nachfolgend noch genannten Isolierteils miteinander verbunden werden. Alternativ oder zusätzlich kann es vorgesehen sein, die Außenleiterkontaktelemente eines mehrteiligen Außenleiterkontaktelementpaares durch Bördeln aneinander zu fixieren, insbesondere wenn die Außenleiterkontaktelemente als Tiefziehteile ausgebildet sind.

Grundsätzlich kann eine beliebige Verbindungstechnik vorgesehen sein, um die Kontaktelemente eines mehrteiligen Kontaktelementpaares miteinander zu verbinden (formschlüssig, kraftschlüssig und/oder stoffschlüssig).

In einer vorteilhaften Weiterbildung der Erfindung kann vorgesehen sein, dass die dritte Schnittstelle zur Verbindung des zumindest einen Kontaktelementpaares mit der elektrischen Leiterplatte zumindest ein Kontaktierungsmittel pro Kontaktelementpaar aufweist. Vorzugsweise erstreckt sich das Kontaktierungsmittel ausgehend von dem jeweiligen Kontaktelementpaar von der Längsachse des Steckverbinders weg.

Das zumindest eine Kontaktierungsmittel bzw. die dritte Schnittstelle erstreckt sich damit vorzugsweise in radialer Richtung, besonders bevorzugt orthogonal zu der Längsachse des Steckverbinders, insbesondere orthogonal zu einer Einsteckrichtung des Gegensteckverbinders in die erste Schnittstelle bzw. in die zweite Schnittstelle.

Die dritte Schnittstelle kann ausgebildet sein, um einen Übergang zwischen einem ersten Leitungssystem (vorzugsweise einem koaxialen Leitungssystem), das zwischen der ersten Schnittstelle und der zweiten Schnittstelle ausgebildet ist, und einem zweiten Leitungssystem (vorzugsweise einem nicht koaxialen Leitungssystem) zu realisieren.

Vorzugsweise ist die dritte Schnittstelle elektrisch und mechanisch abweichend von der ersten Schnittstelle und der zweiten Schnittstelle ausgebildet. Insbesondere kann vorgesehen sein, dass die dritte Schnittstelle nicht mit einem Gegensteckverbinder verbindbar ist. Vorzugsweise bildet die dritte Schnittstelle keinen Steckplatz aus.

In einer Weiterbildung der Erfindung kann vorgesehen sein, dass die dritte Schnittstelle wenigstens einen Kontaktkörper aufweist, insbesondere dass das zumindest eine Kontaktierungsmittel als Kontaktkörper ausgebildet ist, der sich in radialer Richtung ausgehend von zumindest einem der Kontaktelemente eines gemeinsamen Kontaktelementpaares erstreckt. Vorzugsweise ist ein länglicher Kontaktkörper vorgesehen, beispielsweise eine Kontaktfahne, ein Kontaktstift oder eine Einzelleitung.

Vorzugsweise weist zumindest eines der Innenleiterkontaktelemente eines gemeinsamen Innenleiterkontaktelementpaares wenigstens einen entsprechenden Kontaktkörper auf (vorzugsweise genau einen Kontaktkörper).

Ein optional vorhandenes Außenleiterkontaktelement und/oder ein optional vorhandenes, nachfolgend noch näher beschriebenes Isolierelement kann bzw. können entsprechende Durchführungen zur Durchführung des Kontaktkörpers aufweisen.

Der Kontaktkörper, beispielsweise eine Kontaktfahne kann auf einem Kontaktabschnitt, beispielsweise auf einem Kontaktpad bzw. auf einer Lötfläche, der elektrischen Leiterplatte befestigt bzw. verlötet sein. Auf diese Weise kann einerseits eine elektrische als auch eine mechanische Verbindung hergestellt werden.

Grundsätzlich kann ein Kontaktelementpaar genau einen Kontaktkörper oder auch mehrere Kontaktkörper aufweisen. Vorzugsweise weist nur eines der Kontaktelemente eines gemeinsamen Kontaktelementpaares Kontaktkörper auf, insbesondere einen einzelnen Kontaktkörper (optional allerdings auch noch mehr Kontaktkörper für eine verbesserte elektrische und mechanische Verbindung mit der Leiterplatte). Es kann auch vorgesehen sein, dass beide Kontaktelemente eines gemeinsamen Kontaktelementpaares jeweils einen Kontaktkörper oder mehrere Kontaktkörper aufweisen. Beispielsweise kann ein Kontaktkörper pro Kontaktelement vorgesehen sein.

In einer Weiterbildung der Erfindung kann vorgesehen sein, dass die dritte Schnittstelle wenigstens eine Lötfläche aufweist, insbesondere dass das zumindest eine Kontaktierungsmittel als Lötfläche ausgebildet ist, die an zumindest einem der Kontaktelemente eines gemeinsamen Kontaktelementpaares ausgebildet ist.

Vorzugweise weist wenigstens eines der Außenleiterkontaktelemente eines gemeinsamen Außenleiterkontaktelementpaares eine Lötfläche zur Verbindung mit entsprechenden Kontaktabschnitten auf der elektrischen Leiterplatte auf. Auf diese Weise kann eine besonders gute elektrische und mechanische Verbindung zwischen dem Außenleiterkontaktelement und der elektrischen Leiterplatte vorgesehen sein.

In einer Weiterbildung der Erfindung kann auch vorgesehen sein, dass die dritte Schnittstelle wenigstens einen Stiftkontakt aufweist, der an zumindest einem der Kontaktelemente eines gemeinsamen Kontaktelementpaares ausgebildet ist. Vorzugsweise ist das zumindest eine Kontaktierungsmittel als (gewinkelter) Kontaktfuß ausgebildet.

Beispielsweise kann das erste Außenleiterkontaktelement und/oder das zweite Außenleiterkontaktelement eines gemeinsamen Außenleiterkontaktelementpaares wenigstens einen der genannten Stiftkontakte aufweisen, vorzugsweise mehrere ringförmig umlaufend angeordnete Stiftkontakte, besonders bevorzugt in äquidistanter oder rasterförmiger Anordnung.

Die Stiftkontakte können in entsprechende Kontaktaufnahmen, insbesondere in Durchkontaktierungen ("Vias"), in der Leiterplatte eingeführt und beispielsweise auf der Leiterplatte verlötet oder in der jeweiligen Kontaktaufnahme durch Presspassung befestigt werden.

In einer Weiterbildung der Erfindung kann vorgesehen sein, dass der elektrische Steckverbinder ein die Kontaktelementpaare elektrisch voneinander isolierendes Isolierelement aufweist, das zwischen der ersten Schnittstelle und der zweiten Schnittstelle (bzw. zwischen dem ersten Endabschnitt und dem zweiten Endabschnitt) angeordnet ist.

Das Isolierelement kann grundsätzlich zur Befestigung und/oder mechanischen Stabilisierung der Kontaktelemente und zu deren Beabstandung ausgebildet sein. Das Isolierelement kann vorzugsweise der Beabstandung und mechanischen Stabilisierung des elektrischen Steckverbinders im Übergangsbereich zwischen den beiden Steckplätzen bzw. zwischen der ersten Schnittstelle und der zweiten Schnittstelle dienen.

Das Isolierelement kann kraftschlüssig, formschlüssig und/oder stoffschlüssig innerhalb des Außenleiterkontaktelements montiert sein. Eines oder mehrere Innenleiterkontaktelemente können innerhalb des Isolierelements kraftschlüssig, formschlüssig und/oder stoffschlüssig montiert sein.

Vorzugsweise ist das Isolierelement in zumindest eines der Außenleiterkontaktelemente eines gemeinsamen Außenleiterkontaktelementpaares eingepresst und/oder mit zumindest einem der Außenleiterkontaktelemente verrastet. Das Isolierelement kann gegebenenfalls auch in ein Außenleiterkontaktelementpaar eingespritzt sein.

In einer vorteilhaften Weiterbildung der Erfindung kann vorgesehen sein, dass das Isolierelement mehrteilig ausgebildet ist, insbesondere zweiteilig ausgebildet ist.

Im Falle einer mehrteiligen Ausgestaltung des Isolierelements kann die Montage des wenigstens einen Innenleiterkontaktelements vereinfacht sein.

Beispielsweise kann das Isolierelement aus einem ersten Isolierteil und einem zweiten Isolierteil ausgebildet sein, die kraftschlüssig, formschlüssig und/oder stoffschlüssig miteinander verbindbar sind. Besonders bevorzugt sind die Isolierteile des Isolierelements miteinander verrastbar. Hierfür können die Isolierteile entsprechende Rasthaken und Rastaufnahmen aufweisen, beispielsweise genau einen Rasthaken und genau eine Rastaufnahme pro Isolierteil.

Auch eine einteilige Ausgestaltung des Isolierelements kann allerdings vorgesehen sein. In diesem Fall kann optional vorgesehen sein, dass das Isolierelement ein Filmscharnier oder eine sonstige Schwenkachse bzw. ein sonstiges Gelenk aufweist, um die Montage eines Innenleiterkontaktelements zu vereinfachen oder überhaupt zu ermöglichen.

In einer vorteilhaften Weiterbildung der Erfindung kann vorgesehen sein, dass das Isolierelement einen ringförmig umlaufenden Außenmantel aufweist.

Ausgehend von dem Außenmantel können sich optional mehrere Stege erstrecken, vorzugsweise drei oder mehr äquidistant auf dem Außenmantel verteilt angeordnete Stege, besonders bevorzugt vier oder mehr äquidistant auf dem Außenmantel verteilt angeordnete Stege.

Vorzugweise sind genau vier Stege vorgesehen, die äquidistant auf dem Außenmantel verteilt angeordnet sind.

Das Isolierelement kann mittels der Stege in einem Außenleiterkontaktelement montiert sein, vorzugsweise verrastet und/oder verpresst sein.

Die Stege können insbesondere von Vorteil sein, um eine verdrehsichere Montage des Gegensteckverbinders zu ermöglichen. Der Gegensteckverbinder kann korrespondierende Aufnahmeabschnitte für die Stege aufweisen.

Die Stege können außerdem Anschläge für den Gegensteckverbinder ausbilden.

In einer vorteilhaften Weiterbildung der Erfindung kann vorgesehen sein, dass das Isolierelement einen stirnseitigen Anschlag für den Gegensteckverbinder ausbildet.

Insbesondere kann vorgesehen sein, dass das Isolierelement einen stirnseitigen Anschlag für einen Außenleiter des Gegensteckverbinders ausbildet. Es kann von dem Isolierelement des Steckverbinders alternativ oder zusätzlich aber auch ein Anschlag für einen Innenleiter und/oder einen Isolator des Gegensteckverbinders bereitgestellt werden. Ein Anschlag für den Außenleiter des Gegensteckverbinders ist allerdings bevorzugt.

Durch den stirnseitigen Anschlag kann sichergestellt sein, dass selbst bei einer schrägen Ausrichtung des Gegensteckverbinders, beispielsweise verursacht durch Vibrationen im Betrieb, Montagetoleranzen und/oder Stecktoleranzen, ein nichtlineares Übertragungsverhalten (passive Intermodulation) vermieden wird, da stirnseitige, sporadische Kontaktverluste bei der Außenleiterkontaktierung nicht auftreten können, insbesondere wenn das Isolierelement eine stirnseitige Kontaktierung zwischen dem Außenleiter des Gegensteckverbinders und dem Außenleiterkontaktelement des Steckverbinders blockiert.

Der elektrische Steckverbinder kann insbesondere als Steckverbinder für die Hochfrequenztechnik ausgebildet sein (HF-Steckverbinder). Der elektrische Steckverbinder kann insbesondere für eine Übertragung von elektrischen Signalen im MHz- bis THz-Bereich ausgebildet sein, beispielsweise zur Übertragung von elektrischen Signalen von 1 MHz bis 100 GHz, vorzugsweise 5 MHz bis 70 GHz. Der elektrische Steckverbinder kann allerdings auch zur Übertragung von elektrischen DC-Signalen verwendbar sein. Insbesondere kann auch eine überlagerte Signalübertragung vorgesehen sein, wonach ein HF-Signal auf ein DC-Signal aufmoduliert wird.

Die Erfindung betrifft auch eine Leiterplattenanordnung, aufweisend einen elektrischen Steckverbinder gemäß den vorstehenden und nachfolgenden Ausführungen und die elektrische Leiterplatte, wobei der Steckverbinder in einer Ausnehmung innerhalb der Leiterplatte aufgenommen und über die dritte Schnittstelle mit wenigstens einer elektrischen Leitung (insbesondere einer Leiterbahn) der Leiterplatte verbunden ist.

Auf vorteilhafte Weise kann eine beidseitige Zugänglichkeit der elektrischen Leiterplatte für deren Kontaktierung mit einer weiteren Leiterplatte bereitgestellt werden, ohne dass ein jeweiliger Steckverbinder auf beiden Seiten der Leiterplatte aufgelötet werden muss. Eine doppelseitige Bestückung der Leiterplatte kann dadurch vermieden werden.

Ferner kann durch den erfindungsgemäßen Steckverbinder optional sichergestellt werden, dass lediglich ein einziger Gegensteckverbinder in den Steckverbinder eingesteckt wird.

Durch die erfindungsgemäße Leiterplattenanordnung kann vorzugsweise eine besonders wirtschaftliche und flexible Board-zu-Board-Verbindung geschaffen werden, die es erlaubt, dieselbe Platine von einer beliebigen oder von beiden Seiten zu kontaktieren.

Vorzugsweise ist die Längsachse des elektrischen Steckverbinders orthogonal (bzw. vertikal) oder zumindest im Wesentlichen orthogonal zu den sich gegenüberliegenden Hauptflächen der Leiterplatte ausgerichtet. Der Steckverbinder kann grundsätzlich aber auch gekippt zu der Leiterplatte ausgerichtet sein, beispielsweise um bis zu 45°, um bis zu 20°, um bis zu 10° oder um bis zu 5° relativ zu einer orthogonalen Ausrichtung verkippt ausgerichtet sein.

Die Ausnehmung der Leiterplatte ist vorzugsweise als kreisförmige Bohrung ausgebildet. Grundsätzlich kann die Ausnehmung allerdings eine beliebige Geometrie aufweisen und damit beispielsweise auch rechteckig ausgebildet sein.

Die Verbindung zwischen der Leiterplatte und dem elektrischen Steckverbinder kann für das zumindest eine Kontaktelementpaar bevorzugt über eine Lötverbindung, gegebenenfalls aber auch kraftschlüssig durch Kontaktdruck oder durch ein beliebiges anderes Verfahren erfolgen.

Zur elektrischen Verbindung kann die Leiterplatte Leiterbahnen / Streifenleiter in allen gängigen Technologien aufweisen (beispielsweise einfache Leiterbahnen einer gedruckten Schaltung, aber auch Mikrostreifenleitungen, Koplanarleitungen etc.). Die Kontaktierung kann vorzugsweise auf einer Oberfläche der Leiterplatte, optional allerdings auch innerhalb der (optional leitfähig beschichteten) Ausnehmung oder innerhalb einer Durchkontaktierung erfolgen.

Die Leiterplattenanordnung kann zumindest einen der Gegensteckverbinder aufweisen, der mit der ersten Schnittstelle oder der zweiten Schnittstelle verbindbar oder verbunden ist.

Die Leiterplattenanordnung kann zumindest eine weitere Leiterplatte aufweisen, die über wenigstens einen der Gegensteckverbinder mit der vorgenannten Leiterplatte verbunden ist. Vorzugsweise weist hierzu auch die weitere Leiterplatte einen der vorgenannten elektrischen Steckverbinder auf.

Die Erfindung betrifft auch eine elektrische Steckverbindung, aufweisend einen elektrischen Steckverbinder gemäß den vorstehenden und nachfolgenden Ausführungen und zumindest einen elektrischen Gegensteckverbinder, der mit der ersten Schnittstelle und/oder mit der zweiten Schnittstelle verbindbar ist.

Der erfindungsgemäße Steckverbinder eignet sich grundsätzlich für beliebige Anwendungen innerhalb der gesamten Elektrotechnik. Insbesondere ist allerdings die Kommunikationstechnik und Radartechnik, vornehmlich die Mobilfunktechnik, ein besonders vorteilhaftes Anwendungsgebiet der Erfindung. Mögliche Anwendungen der Erfindung können beispielsweise Basisstationen oder sonstige aktive Komponenten eines Mobilfunksystems betreffen.

Die Erfindung betrifft außerdem ein elektrisches System, aufweisend die Leiterplattenanordnung gemäß den vorstehenden und nachfolgenden Ausführungen und eine mit der elektrischen Leiterplatte der Leiterplattenanordnung verbindbare weitere elektrische Leiterplatte. Besonders bevorzugt weist das elektrische System zwei über einen gemeinsamen Gegensteckverbinder miteinander verbindbare Leiterplattenanordnungen gemäß den vorstehenden und nachfolgenden Ausführungen auf.

Die Erfindung betrifft auch ein Verfahren zur Montage einer Leiterplattenanordnung, wonach ein elektrischer Steckverbinder, aufweisend einen ersten Endabschnitt, an dem eine erste Schnittstelle angeordnet ist und einen zweiten Endabschnitt, an dem eine zweite Schnittstelle angeordnet ist, durch eine Ausnehmung in einer elektrischen Leiterplatte hindurchgeführt und an der Leiterplatte befestigt wird, wobei die erste Schnittstelle mit der zweiten Schnittstelle wenigstens zwei Kontaktelementpaare ausbildet, wobei jedes der Kontaktelementpaare ein erstes Kontaktelement aufweist, das der ersten Schnittstelle zugeordnet ist und ein mit dem ersten Kontaktelement mechanisch verbundenes zweites Kontaktelement aufweist, das der zweiten Schnittstelle zugeordnet ist, und wobei zwischen dem ersten Endabschnitt und dem zweiten Endabschnitt eine nicht-koaxiale, dritte Schnittstelle vorgesehen ist, über die zumindest eines der Kontaktelementpaare elektrisch und mechanisch mit der Leiterplatte verbunden wird.

Vorzugsweise kann eine Leiterplatte eines elektrischen Systems, das mehrere miteinander zu verbindende elektrische Leiterplatten aufweist, wahlweise in einer ersten Ausrichtung oder in einer um 180° ("über Kopf') verdrehten zweiten Ausrichtung montiert werden.

Schließlich betrifft die Erfindung auch ein Verfahren zur Herstellung eines elektrischen Steckverbinders gemäß den vorstehenden und nachfolgenden Ausführungen.

Als Fertigungsverfahren zur Herstellung des elektrischen Steckverbinders und seiner Steckverbinderkomponenten können vorzugsweise formende Verfahren wie Stanzen, Biegen, Tiefziehen und Spritzgießen eingesetzt werden. Beispielsweise kann das Innenleiterkontaktelement bzw. das Innenleiterkontaktelementpaar durch einen Stanzprozess, einen Rollprozess, einen Biegeprozess, einen Prägeprozess, einen Drehprozess, einen Tiefziehprozess und/oder einen Pressprozess hergestellt werden.

Merkmale, die im Zusammenhang mit einem der Gegenstände der Erfindung, namentlich gegeben durch den erfindungsgemäßen elektrischen Steckverbinder, die erfindungsgemäße elektrische Steckverbindung, die erfindungsgemäße Leiterplattenanordnung, das erfindungsgemäße elektrische System, das erfindungsgemäße Verfahren zur Montage einer Leiterplattenanordnung oder das erfindungsgemäße Verfahren zur Herstellung eines elektrischen Steckverbinders beschrieben wurden, sind auch für die anderen Gegenstände der Erfindung vorteilhaft umsetzbar. Ebenso können Vorteile, die im Zusammenhang mit einem der Gegenstände der Erfindung genannt wurden, auch auf die anderen Gegenstände der Erfindung bezogen verstanden werden.

Ergänzend sei darauf hingewiesen, dass Begriffe wie "umfassend", "aufweisend" oder "mit" keine anderen Merkmale oder Schritte ausschließen. Ferner schließen Begriffe wie "ein" oder "das", die auf eine Einzahl von Schritten oder Merkmalen hinweisen, keine Mehrzahl von Merkmalen oder Schritten aus - und umgekehrt.

In einer puristischen Ausführungsform der Erfindung kann allerdings auch vorgesehen sein, dass die in der Erfindung mit den Begriffen "umfassend", "aufweisend" oder "mit" eingeführten Merkmale abschließend aufgezählt sind. Dementsprechend kann eine oder können mehrere Aufzählungen von Merkmalen im Rahmen der Erfindung als abgeschlossen betrachtet werden, beispielsweise jeweils für jeden Anspruch betrachtet. Die Erfindung kann beispielsweise ausschließlich aus den in Anspruch 1 genannten Merkmalen bestehen.

Es sei erwähnt, dass Bezeichnungen wie "erstes" oder "zweites" etc. vornehmlich aus Gründen der Unterscheidbarkeit von jeweiligen Vorrichtungs- oder Verfahrensmerkmalen verwendet werden und nicht unbedingt andeuten sollen, dass sich Merkmale gegenseitig bedingen oder miteinander in Beziehung stehen.

Ferner sei betont, dass die vorliegend beschriebenen Werte und Parameter Abweichungen oder Schwankungen von ±10% oder weniger, vorzugsweise ±5% oder weniger, weiter bevorzugt ±1 % oder weniger, und ganz besonders bevorzugt ±0,1 % oder weniger des jeweils benannten Wertes bzw. Parameters mit einschließen, sofern diese Abweichungen bei der Umsetzung der Erfindung in der Praxis nicht ausgeschlossen sind. Die Angabe von Bereichen durch Anfangs- und Endwerte umfasst auch all diejenigen Werte und Bruchteile, die von dem jeweils benannten Bereich eingeschlossen sind, insbesondere die Anfangs- und Endwerte und einen jeweiligen Mittelwert.

Die Erfindung betrifft auch einen von Anspruch 1 unabhängigen elektrischen oder optischen Steckverbinder mit einer ersten Schnittstelle und einer zweiten Schnittstelle, wobei die erste Schnittstelle und die zweite Schnittstelle jeweils mit einem Gegensteckverbinder verbindbar sind, und wobei die erste Schnittstelle mit der zweiten Schnittstelle wenigstens ein Kontaktelementpaar ausbildet, wobei der Steckverbinder mittels einer dritten Schnittstelle mit einer Leiterplatte verbunden ist. Die weiteren Merkmale des Anspruchs 1 und der abhängigen Ansprüche sowie die in der vorliegenden Beschreibung beschriebenen Merkmale betreffen vorteilhafte Ausführungsformen und Varianten dieses Steckverbinders.

Nachfolgend werden Ausführungsbeispiele der Erfindung anhand der Zeichnung näher beschrieben.

Die Figuren zeigen jeweils bevorzugte Ausführungsbeispiele, in denen einzelne Merkmale der vorliegenden Erfindung in Kombination miteinander dargestellt sind. Merkmale eines Ausführungsbeispiels sind auch losgelöst von den anderen Merkmalen des gleichen Ausführungsbeispiels umsetzbar und können dementsprechend von einem Fachmann ohne Weiteres zu weiteren sinnvollen Kombinationen und Unterkombinationen mit Merkmalen anderer Ausführungsbeispiele verbunden werden.

In den Figuren sind funktionsgleiche Elemente mit denselben Bezugszeichen versehen.

Es zeigen schematisch:
- Figur 1: einen mit einer elektrischen Leiterplatte verbundenen elektrischen Steckverbinder gemäß einem ersten Ausführungsbeispiel der Erfindung zusammen mit zwei elektrische Gegensteckverbindern in einer perspektivischen Darstellung;
- Figur 2: den elektrischen Steckverbinder des ersten Ausführungsbeispiels in einer perspektivischen Explosionsdarstellung;
- Figur 3: eine perspektivische Einzeldarstellung eines elektrischen Gegensteckverbinders der Figur 1 ;
- Figur 4: den elektrischen Steckverbinder und die elektrische Leiterplatte des ersten Ausführungsbeispiels in einer Schnittdarstellung;
- Figur 5: den elektrischen Steckverbinder und die elektrische Leiterplatte des ersten Ausführungsbeispiels in einer Schnittdarstellung zusammen mit einem gesteckten Gegensteckverbinder;
- Figur 6: den elektrischen Steckverbinder und die elektrische Leiterplatte des ersten Ausführungsbeispiels in einer Schnittdarstellung zusammen mit zwei gesteckten Gegensteckverbindern;
- Figur 7: ein stiftförmiges Innenleiterkontaktelementpaar gemäß einer ersten Variante der Erfindung in einer perspektivischen Einzeldarstellung;
- Figur 8: ein stiftförmiges Innenleiterkontaktelementpaar gemäß einer zweiten Variante der Erfindung in einer perspektivischen Einzeldarstellung;
- Figur 9: ein stiftförmiges Innenleiterkontaktelementpaar gemäß einer dritten Variante der Erfindung während der Montage in einer perspektivischen Einzeldarstellung;
- Figur 10: das Innenleiterkontaktelementpaar der dritten Variante der Erfindung nach der Montage in einer perspektivischen Einzeldarstellung;
- Figur 11: ein stiftförmiges Innenleiterkontaktelementpaar gemäß einer vierten Variante der Erfindung während der Montage in einer perspektivischen Einzeldarstellung;
- Figur 12: das Innenleiterkontaktelementpaar der vierten Variante der Erfindung nach der Montage in einer perspektivischen Einzeldarstellung;
- Figur 13: ein einteiliges Isolierelement zur Aufnahme eines Innenleiterkontaktelementpaares mit einem Filmscharnier in geöffnetem Zustand in einer perspektivischen Einzeldarstellung;
- Figur 14: das Isolierelement der Figur 13 in geschlossenem Zustand in einer perspektivischen Einzeldarstellung;
- Figur 15: einen mit einer elektrischen Leiterplatte verbundenen elektrischen Steckverbinder gemäß einem zweiten Ausführungsbeispiel der Erfindung in einer perspektivischen Schnittdarstellung;
- Figur 16: einen mit einer elektrischen Leiterplatte verbundenen elektrischen Steckverbinder gemäß einem dritten Ausführungsbeispiel der Erfindung in einer perspektivischen Schnittdarstellung;
- Figur 17: den elektrischen Steckverbinder des dritten Ausführungsbeispiels mit einem gesteckten Gegensteckverbinder in einer perspektivischen Schnittdarstellung;
- Figur 18: einen mit einer elektrischen Leiterplatte verbundenen elektrischen Steckverbinder gemäß einem vierten Ausführungsbeispiel der Erfindung während der Montage in einer perspektivischen Schnittdarstellung;
- Figur 19: den elektrischen Steckverbinder des vierten Ausführungsbeispiels nach der Montage in einer perspektivischen Schnittdarstellung;
- Figur 20: einen mit einer elektrischen Leiterplatte verbundenen elektrischen Steckverbinder gemäß einem fünften Ausführungsbeispiel der Erfindung in einer perspektivischen Explosionsdarstellung;
- Figur 21: das zweiteilige Isolierteil des elektrischen Steckverbinders des fünften Ausführungsbeispiels während der Montage des Innenleiterkontaktelementpaares in einer perspektivischen Darstellung;
- Figur 22: das zweiteilige Isolierteil des elektrischen Steckverbinders des fünften Ausführungsbeispiels nach der Montage des Innenleiterkontaktelementpaares in einer perspektivischen Darstellung;
- Figur 23: den elektrischen Steckverbinder und die elektrische Leiterplatte des fünften Ausführungsbeispiels in einer Schnittdarstellung;
- Figur 24: den elektrischen Steckverbinder und die elektrische Leiterplatte des fünften Ausführungsbeispiels in einer Schnittdarstellung zusammen mit zwei gesteckten Gegensteckverbindern;
- Figur 25: einen mit einer elektrischen Leiterplatte verbundenen elektrischen Steckverbinder gemäß einem sechsten Ausführungsbeispiel der Erfindung in einer perspektivischen Darstellung;
- Figur 26: den elektrischen Steckverbinder und die elektrische Leiterplatte des sechsten Ausführungsbeispiels in einer perspektivischen Explosionsdarstellung;
- Figur 27: das zweiteilige Isolierteil des elektrischen Steckverbinders des sechsten Ausführungsbeispiels während der Montage des Innenleiterkontaktelementpaares in einer perspektivischen Darstellung;
- Figur 28: das zweiteilige Isolierteil des elektrischen Steckverbinders des sechsten Ausführungsbeispiels nach der Montage des Innenleiterkontaktelementpaares in einer perspektivischen Darstellung;
- Figur 29: eine Visualisierung der Zusammenwirkung des gesteckten Gegensteckverbinders mit dem zweiteiligen Isolierteil des elektrischen Steckverbinders des sechsten Ausführungsbeispiels in einer perspektivischen Darstellung;
- Figur 30: den elektrischen Steckverbinder und die elektrische Leiterplatte des sechsten Ausführungsbeispiels in einer Schnittdarstellung; und
- Figur 31: den elektrischen Steckverbinder und die elektrische Leiterplatte des sechsten Ausführungsbeispiels in einer Schnittdarstellung zusammen mit einem gesteckten Gegensteckverbinder.

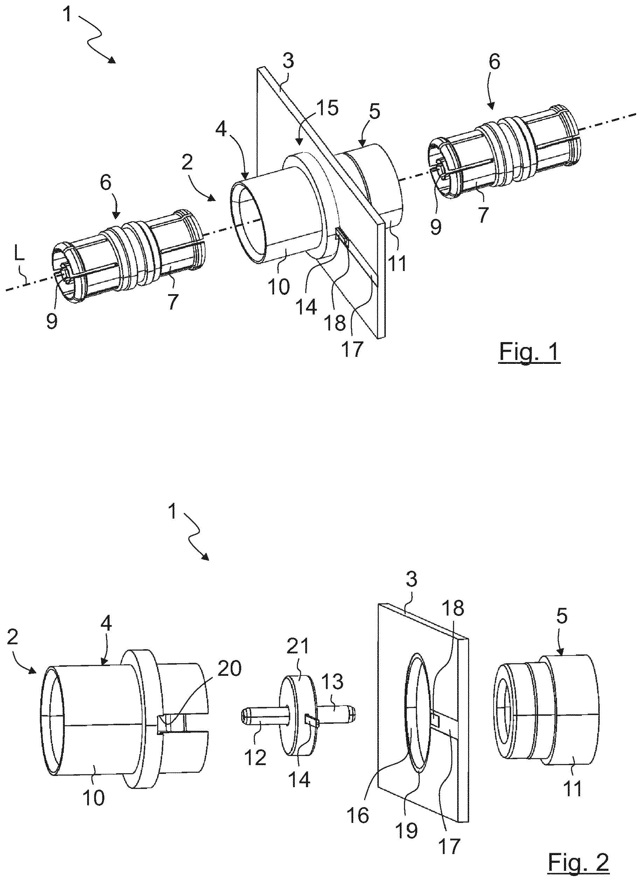

Figur 1 zeigt eine Leiterplattenanordnung 1 gemäß einem ersten Ausführungsbeispiel der Erfindung in einer perspektivischen Darstellung. Die Leiterplattenanordnung 1 weist einen elektrischen Steckverbinder 2 (Leiterplattensteckverbinder) und eine elektrische Leiterplatte 3 auf.

Der elektrische Steckverbinder 2 weist einen ersten Endabschnitt auf, an dem eine erste Schnittstelle 4 bzw. ein erster Steckplatz angeordnet ist. Der elektrische Steckverbinder 2 weist ferner einen zweiten Endabschnitt auf, an dem eine zweite Schnittstelle 5 bzw. ein zweiter Steckplatz angeordnet ist. Die erste Schnittstelle 4 und die zweite Schnittstelle 5 sind jeweils mit einem elektrischen Gegensteckverbinder 6 verbindbar.

Der elektrische Steckverbinder 2 kann ausgebildet sein, um ein Stecken eines Gegensteckverbinders 6 wahlweise von einer der beiden Seiten der Leiterplatte 3 oder gegebenenfalls auch gleichzeitig von beiden Seiten der Leiterplatte 3 zu ermöglichen.

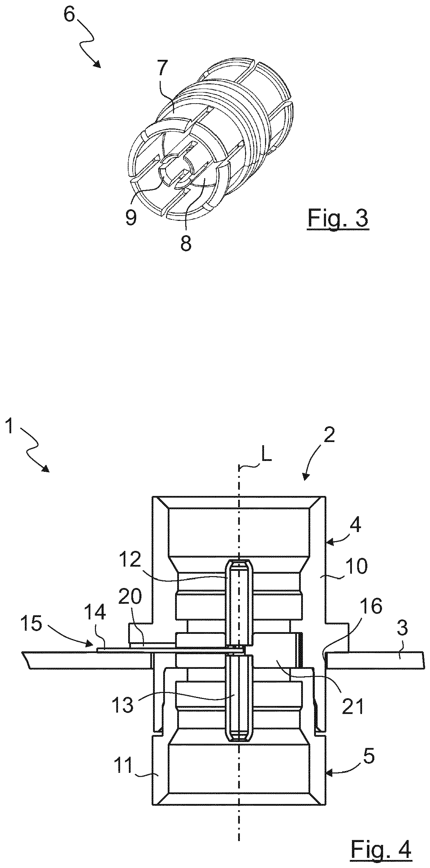

Ein mit dem Steckverbinder 2 korrespondierender, beispielhafter Gegensteckverbinder 6 ist in einer perspektivischen Einzeldarstellung in Figur 3 gezeigt. Der Gegensteckverbinder 6 weist einen Außenleiter 7 auf, der in den Ausführungsbeispielen beispielhaft in seinen zur Kontaktierung vorgesehenen Abschnitten in der Art eines Federkorbs ausgebildet ist. Koaxial innerhalb des Außenleiters 7 ist ein Isolator 8 vorgesehen, in dem wiederum koaxial ein Innenleiter 9 verläuft, der beispielhaft einzelne Federlaschen aufweist. Grundsätzlich kann ein beliebiger Aufbau des Gegensteckverbinders 6 vorgesehen sein. Der dargestellte Aufbau als Verbindungselement eignet sich insbesondere, um zwei Leiterplattenanordnungen 1 durch einen gemeinsamen Gegensteckverbinder 6 elektrisch und mechanisch miteinander zu verbinden. Auf diese Weise kann eine besonders vorteilhafte Board-zu-Board-Verbindung bereitgestellt werden. Grundsätzlich kann der Gegensteckverbinder 6 allerdings auch eine Verbindung der Leiterplattenanordnung 1 mit einem elektrischen Kabel oder einer sonstigen elektrischen Baugruppe ermöglichen. Der Gegensteckverbinder 6 kann somit insbesondere auch als Kabelsteckverbinder ausgebildet sein.

Vorzugsweise weist der elektrische Steckverbinder 2 einen linearen Verlauf zwischen dem ersten Endabschnitt und dem zweiten Endabschnitt bzw. zwischen der ersten Schnittstelle 4 und der zweiten Schnittstelle 5 auf. Die Längsachse L des elektrischen Steckverbinders 2 verläuft somit geradlinig. Grundsätzlich kann der elektrische Steckverbinder 2 allerdings auch winklig ausgebildet sein oder winklige Abschnitte aufweisen, beispielsweise einen winkligen ersten Endabschnitt bzw. eine winklige erste Schnittstelle 4 und/oder einen winkligen zweiten Endabschnitt bzw. eine winklige zweite Schnittstelle 5.

Vorzugsweise sind die erste Schnittstelle 4 und die zweite Schnittstelle 5 jeweils mit einem elektrischen Gegensteckverbinder 6 identischen Steckverbindertyps verbindbar. Die erste Schnittstelle 4 und die zweite Schnittstelle 5 sind damit vorzugsweise funktionell (mechanisch und elektrisch) identisch ausgebildet.

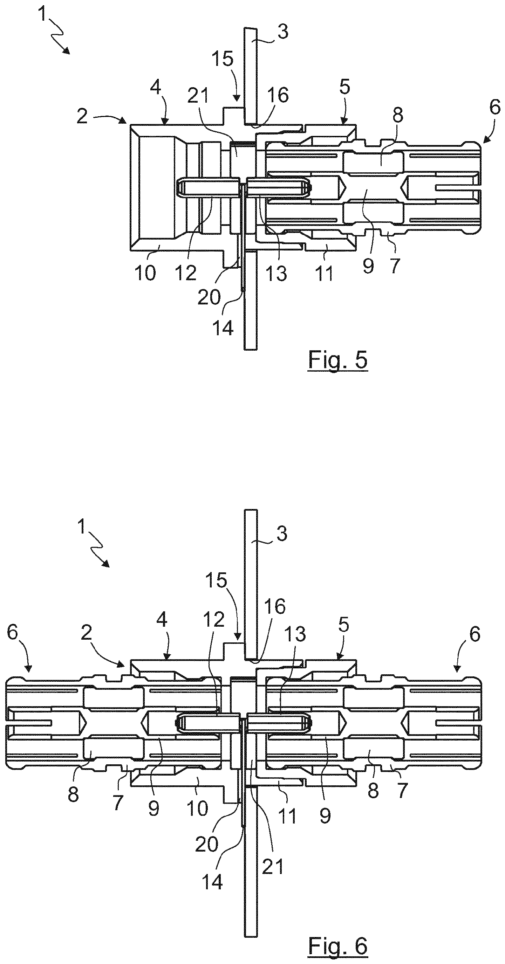

Die Leiterplattenanordnung 1 und der elektrische Steckverbinder 2 sollen nachfolgend noch detaillierter erläutert werden. Figur 2 zeigt hierzu eine perspektivische Explosionsdarstellung der Leiterplattenanordnung 1, Figur 4 eine Schnittdarstellung der Leiterplattenanordnung 1, Figur 5 eine Schnittdarstellung der Leiterplattenanordnung 1 mit einem gesteckten Gegensteckverbinder 6 und Figur 6 eine Schnittdarstellung der Leiterplattenanordnung 1 mit zwei gesteckten Gegensteckverbindern 6.

Die erste Schnittstelle 4 des elektrischen Steckverbinders 2 bildet mit der zweiten Schnittstelle 5 wenigstens zwei Kontaktelementpaare aus, wobei jedes der Kontaktelementpaare ein erstes Kontaktelement 10, 12 aufweist, das der ersten Schnittstelle 4 zugeordnet ist, und ein mit dem ersten Kontaktelement 10, 12 mechanisch verbundenes zweites Kontaktelement 11, 13 aufweist, das der zweiten Schnittstelle 5 zugeordnet ist. In den Ausführungsbeispielen weist der elektrische Steckverbinder 2 einen koaxialen Aufbau auf - dies ist allerdings nur beispielhaft und nicht einschränkend zu verstehen.

In den Ausführungsbeispielen ist vorgesehen, dass eines der Kontaktelementpaare als Außenleiterkontaktelementpaar mit einem ersten Außenleiterkontaktelement 10 und mit einem zweiten Außenleiterkontaktelement 11 ausgebildet ist.

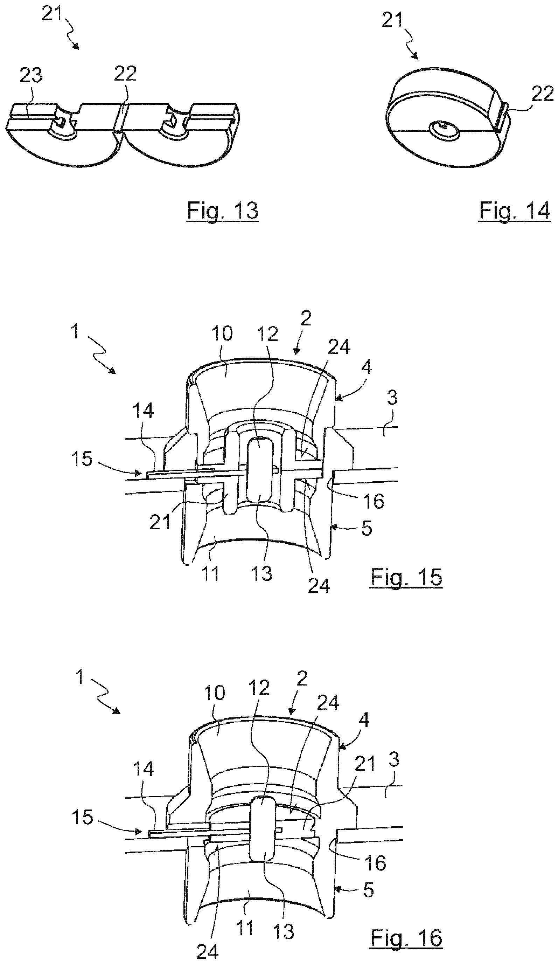

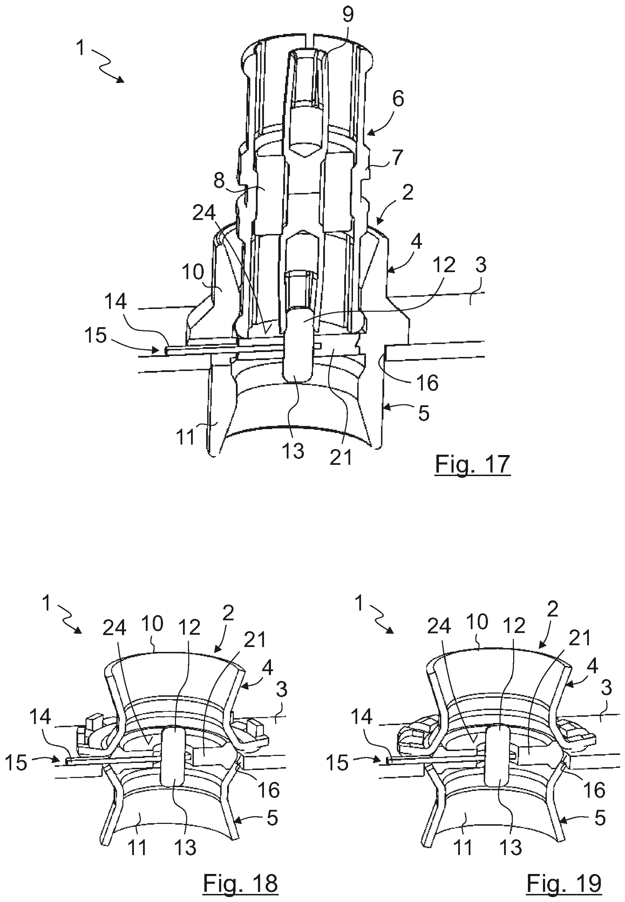

Der elektrische Steckverbinder 2 des ersten Ausführungsbeispiels weist ein zweiteiliges Außenleiterkontaktelementpaar auf. Grundsätzlich können die Außenleiterkontaktelemente 10, 11 eines gemeinsamen Außenleiterkontaktelementpaares allerdings auch einteilig ausgebildet sein (vgl. beispielsweise die nachfolgend noch beschriebenen Figuren 16 und 17).

Ein zweites Kontaktelementpaar ist als Innenleiterkontaktelementpaar mit einem jeweiligen ersten Innenleiterkontaktelement 12 und einem jeweiligen zweiten Innenleiterkontaktelement 13 ausgebildet. Das Innenleiterkontaktelementpaar ist koaxial innerhalb des Außenleiterkontaktelementpaares angeordnet, wobei die Längsachsen der beiden Außenleiterkontaktelemente 10, 11 des Außenleiterkontaktelementpaares koaxial verlaufen und die Längsachsen der Innenleiterkontaktelemente 12, 13 des Innenleiterkontaktelementpaares ebenfalls koaxial verlaufen.

Die Außenleiterkontaktelemente 10, 11 sind in den Ausführungsbeispielen jeweils hülsenförmig ausgebildet, können grundsätzlich allerdings beliebig ausgestaltet sein.

Die Innenleiterkontaktelemente 12, 13 können ebenfalls beliebig ausgestaltet sein. Beispielhaft sind die Innenleiterkontaktelemente 12, 13 gemäß dem ersten Ausführungsbeispiel und dem nachfolgend noch näher beschriebenen zweiten, dritten und vierten Ausführungsbeispiel der Erfindung als Stiftkontakte ausgebildet.

Die beiden Innenleiterkontaktelemente 12, 13 des gemeinsamen Innenleiterkontaktelementpaares sind vorzugsweise einteilig ausgebildet.

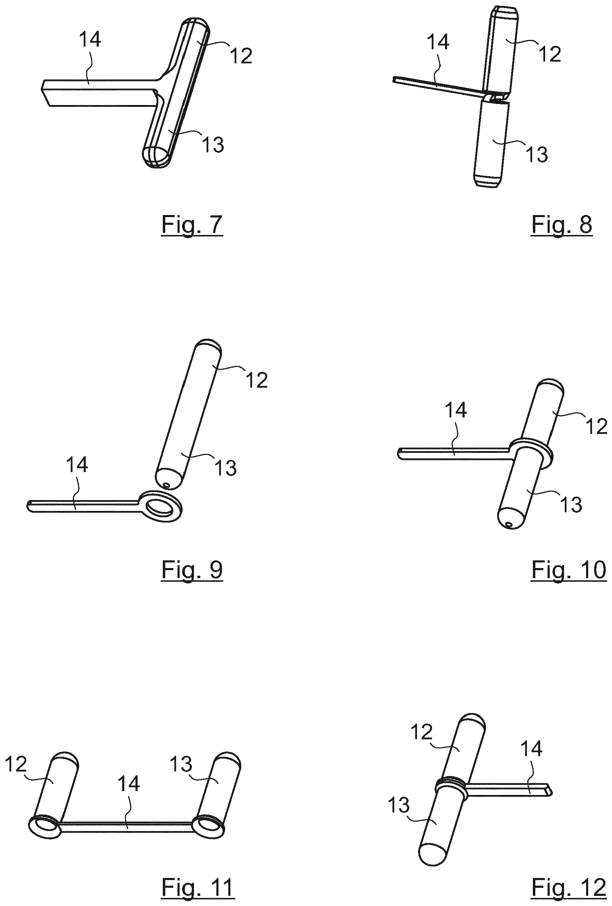

Mögliche Varianten zur Herstellung eines einteiligen, als Stiftkontakt ausgebildeten Innenleiterkontaktelementpaares sind in den Figuren 7 bis 12 gezeigt. Beispielsweise kann ein Innenleiterkontaktelementpaar durch die Verfahrensabfolge Stanzen und Prägen herstellbar sein, wie in Figur 7 gezeigt. Alternativ kann ein in Figur 8 dargestelltes Innenleiterkontaktelementpaar durch die Verfahrensschritte Stanzen, Rollen und Biegen herstellbar sein. Wiederum alternativ kann vorgesehen sein, dass der nachfolgend noch näher beschriebene Kontaktkörper 14 des Innenleiterkontaktelementpaares als Stanzteil und der Stiftkontakt als Drehteil hergestellt werden, die anschließend miteinander verpresst werden, wie sich in Zusammenschau der Figuren 9 und 10 ergibt. Ferner kann auch vorgesehen sein, ein Innenleiterkontaktelementpaar durch Tiefziehen und anschließendes Biegen herzustellen, wie sich anhand der Figuren 11 und 12 ergibt.

Der erfindungsgemäße elektrische Steckverbinder 2 weist zwischen dem ersten Endabschnitt und dem zweiten Endabschnitt (bzw. zwischen der ersten Schnittstelle 4 und der zweiten Schnittstelle 5) eine dritte Schnittstelle 15 auf, um zumindest eines der Kontaktelementpaare, vorzugsweise das Innenleiterkontaktelementpaar und das Außenleiterkontaktelementpaar, jeweils elektrisch und mechanisch mit der Leiterplatte 3 zu verbinden. Vorzugsweise ist die dritte Schnittstelle 15 mittig zwischen der ersten Schnittstelle 4 und der zweiten Schnittstelle 5 angeordnet.

Der elektrische Steckverbinder 2 ist vorzugsweise in einer Ausnehmung 16 der Leiterplatte 3 aufgenommen (die Ausnehmung 16 ist beispielsweise Figur 2 gut erkennbar).

Zur Verbindung der Kontaktelementpaare mit der elektrischen Leiterplatte 3 weist die dritte Schnittstelle 15 entsprechende Kontaktierungsmittel 14 auf, die sich ausgehend von dem jeweiligen Kontaktelementpaar von der Längsachse L des Steckverbinders 2 weg erstrecken. In den Ausführungsbeispielen ist das das Innenleiterkontaktelementpaar mit der Leiterplatte 3 verbindende Kontaktierungsmittel beispielhaft als Kontaktkörper 14 ausgebildet, der sich in radialer Richtung ausgehend von dem ersten Innenleiterkontaktelement 12 des Innenleiterkontaktelementpaares erstreckt. Der Kontaktkörper 14 kann mit einer Leiterbahn 17 (zur Vereinfachung nur in den Figuren 1 und 2 gezeigt) der Leiterplatte 3 verbunden sein, insbesondere auf einem Kontaktabschnitt 18 (z. B. einer Lötfläche) der Leiterplatte 3 verlötet sein. Grundsätzlich kann allerdings eine beliebige Kontaktierungsart zur Kontaktierung eines oder mehrerer Innenleiterkontaktelemente 12, 13 mit der Leiterplatte 3 vorgesehen sein.

An dieser Stelle sei erwähnt, dass das Innenleiterkontaktelementpaar grundsätzlich beliebig viele Kontaktkörper 14 aufweisen kann, beispielsweise einen Kontaktkörper 14 auf jeder Seite der Leiterplatte 3 bzw. einen Kontaktkörper 14 ausgehend von jedem der Innenleiterkontaktelemente 12, 13 des gemeinsamen Innenleiterkontaktelementpaares. Auch eine ringförmig umlaufende Anordnung mehrerer Kontaktkörper 14 kann vorgesehen sein.

Zur Verbindung des Außenleiterkontaktelementpaares mit der elektrischen Leiterplatte 3 kann vorgesehen sein, dass das Außenleiterkontaktelementpaar wenigstens eine Lötfläche aufweist, die mit einer korrespondierenden Lötfläche 19 der Leiterplatte 3 verbindbar ist (vgl. Figur 2). Alternativ oder zusätzlich kann zumindest eines der Außenleiterkontaktelemente 10, 11 beispielsweise auch einen oder mehrere Stiftkontakte aufweisen (nicht dargestellt), die in entsprechende Kontaktausnehmungen der Leiterplatte 3 einfügbar sind. Grundsätzlich sind für die Verbindung des Außenleiterkontaktelementpaares mit der elektrischen Leiterplatte 3 beliebige Verbindungstechniken möglich.

Um die Kontaktierung des Innenleiterkontaktelementpaares mittels des Kontaktkörpers 14 zu ermöglichen weist das Außenleiterkontaktelementpaar eine entsprechende Durchführung 20 auf.

Wie sich besonders gut anhand der Figur 2 ergibt weist der elektrische Steckverbinder 2 ein die Kontaktelementpaare elektrisch voneinander isolierendes Isolierelement 21 auf, das zwischen der ersten Schnittstelle 4 und der zweiten Schnittstelle 5 angeordnet ist. Das Isolierelement 21 kann einteilig oder zweiteilig ausgebildet sein.

Beispielhaft ist in dem ersten Ausführungsbeispiel ein in Figur 13 und 14 separat dargestelltes einteiliges Isolierelement 21 vorgesehen. Zur Montage des Innenleiterkontaktelementpaares weist das einteilige Isolierelement 21 ein Filmscharnier 22 auf. Figur 13 zeigt einen geöffneten und Figur 14 einen geschlossenen Zustand des Isolierelements 21. Um die Durchführung des Kontaktkörpers 14 durch das Isolierelement 21 zu ermöglichen weist das Isolierelement 21 einen entsprechenden Führungskanal 23 auf. Vorzugsweise weist das Isolierelement 21 einen ringförmig umlaufenden Außenmantel auf.

Der elektrische Steckverbinder 2 des ersten Ausführungsbeispiels ist ausgebildet, um eine Kontaktierung mit einem Gegensteckverbinder 6 wahlweise von einer der beiden Seiten der Leiterplatte 3 zu ermöglichen (vgl. beispielsweise Figur 5). Bei dem Steckverbinder 2 des ersten Ausführungsbeispiels ist allerdings auch eine beidseitige Kontaktierung mit zwei Gegensteckverbindern 6 möglich, wie sich anhand von Figur 6 ergibt.

In Figur 15 ist ein zweites Ausführungsbeispiel einer erfindungsgemäßen Leiterplattenanordnung 1 dargestellt, bei dem das Isolierelement 21 das Innenleiterkontaktelementpaar in Längsrichtung vollständig umhüllt.

An dieser Stelle sei erwähnt, dass Merkmale, die bereits im Zusammenhang mit einem anderen Ausführungsbeispiel erwähnt und beschrieben wurden, grundsätzlich nicht erneut im Detail erläutert werden und zur Vereinfachung im Wesentlichen nur auf die Unterschiede zwischen den Ausführungsbeispielen eingegangen wird. In jedem Fall ist eine Kombination von Merkmalen der verschiedenen Ausführungsbeispiele möglich, sofern dies technisch nicht ausgeschlossen ist.

Ein weiteres Ausführungsbeispiel einer erfindungsgemäßen Leiterplattenanordnung 1 ist in den Figuren 16 und 17 gezeigt. Der elektrische Steckverbinder 2 des dritten Ausführungsbeispiels weist ein einteiliges Außenleiterkontaktelementpaar auf.

In Figur 17 ist die Verbindung eines Gegensteckverbinders 6 mit dem elektrischen Steckverbinder 2 des dritten Ausführungsbeispiels der Figur 16 gezeigt. Wie sich besonders gut anhand der Figur 17 ergibt, weist das Isolierelement 21 einen stirnseitigen Anschlag 24 für den Gegensteckverbinder 6 auf (dies gilt auch für die Steckverbinder 2 des zweiten und vierten Ausführungsbeispiels). Auf diese Weise kann vermieden werden, dass zwischen dem Außenleiter 7 des Gegensteckverbinders 6 und dem Außenleiterkontaktelement 10, 11 des Steckverbinders 2 durch mechanisches Wackeln an einem stirnseitigen Kontaktpunkt ein Kontaktverlust entsteht, der zu einem nichtlinearen Übertragungsverhalten führt. Somit kann ein elektrischer Steckverbinder 2 bereitgestellt werden, bei dem eine passive Intermodulation vermieden wird, da zwischen dem Außenleiter 7 des Gegensteckverbinders 6 und dem Außenleiterkontaktelement 10, 11 des Steckverbinders 2 lediglich eine seitliche Kontaktierung bereitgestellt wird.

Ein weiteres Ausführungsbeispiel der Erfindung ist in den Figuren 18 und 19 gezeigt. Der elektrische Steckverbinder 2 der Figuren 18 und 19 weist ein zweiteiliges Außenleiterkontaktelementpaar auf, das mittels Bördeln miteinander mechanisch verbindbar ist.

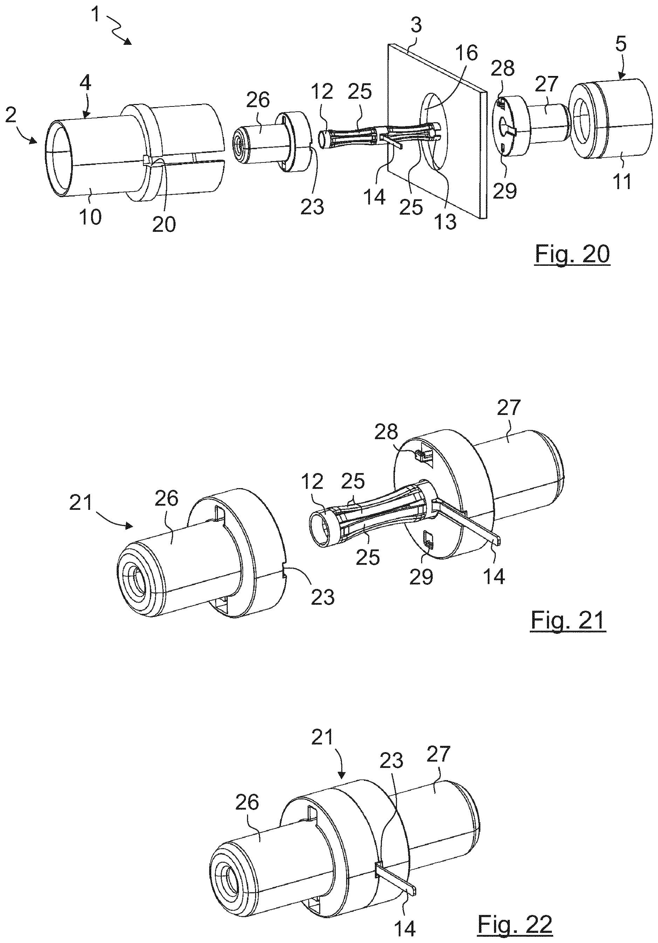

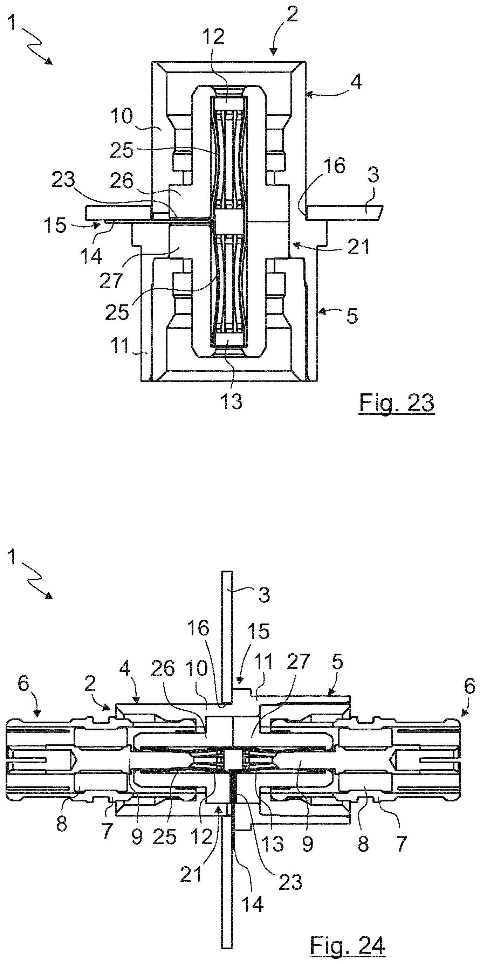

Schließlich ist in den Figuren 20 bis 24 ein fünftes Ausführungsbeispiel einer erfindungsgemäßen Leiterplattenanordnung 1 gezeigt. Figur 20 zeigt hierfür eine perspektivische Explosionsdarstellung und die Figur 23 einen Querschnitt durch die Leiterplattenanordnung 1. In Figur 24 ist die Leiterplattenanordnung 1 des fünften Ausführungsbeispiels bei beidseitig gesteckten Gegensteckverbindern 6 im Querschnitt gezeigt.

Der elektrische Steckverbinder 2 des fünften Ausführungsbeispiels weist ein Innenleiterkontaktelementpaar auf, dessen Innenleiterkontaktelemente 12, 13 als Buchsenkontakte ausgebildet sind. Die Innenleiterkontaktelemente 12, 13 weisen beidseitig angebundene Federlaschen 25 auf, wobei eine der Federlaschen 25 an einem Ende abgetrennt und zur Ausbildung eines Kontaktkörpers 14 umgebogen wurde.

Das Isolierelement 21 des elektrischen Steckverbinders 2 des fünften Ausführungsbeispiels weist einen zweiteiligen Aufbau aus einem ersten Isolierteil 26 und einem zweiten Isolierteil 27 auf. Auf diese Weise kann eine besonders einfache Montage des Innenleiterkontaktelementpaares erfolgen. Das zweiteilige Isolierelement 21 ist in einem unmontierten Zustand in Figur 21 und in einem montierten Zustand in Figur 22 zusammen mit dem Innenleiterkontaktelementpaar gezeigt. Zur Verbindung der beiden Isolierteile 26, 27 kann beispielsweise eine Kombination aus Rasthaken 28 und Rastaufnahmen 29 vorgesehen sein. In dem Ausführungsbeispiel ist beispielhaft vorgesehen, dass jedes der Isolierteile 26, 27 einen Rasthaken 28 und eine Rastaufnahme 29 aufweisen.

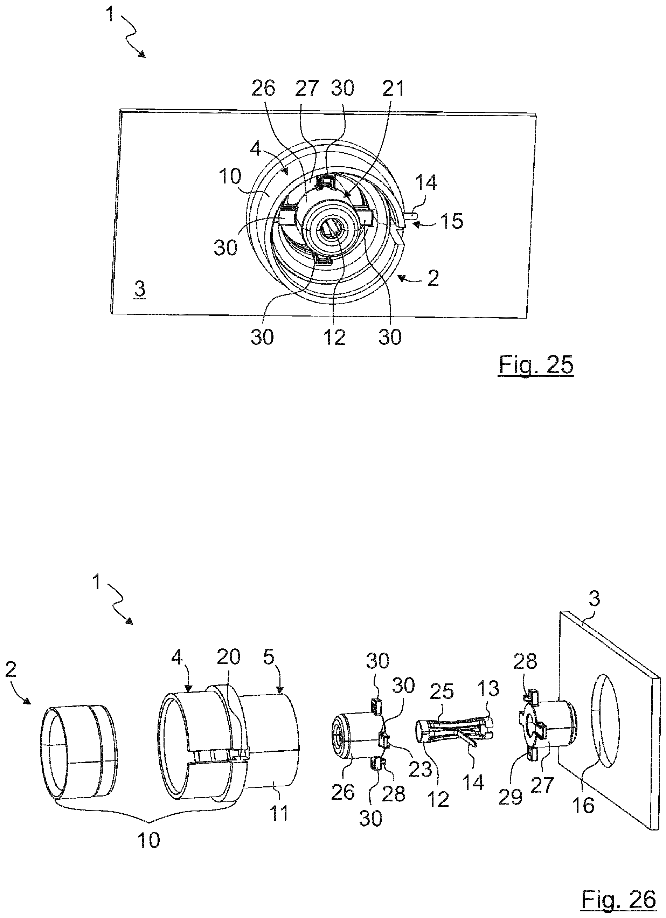

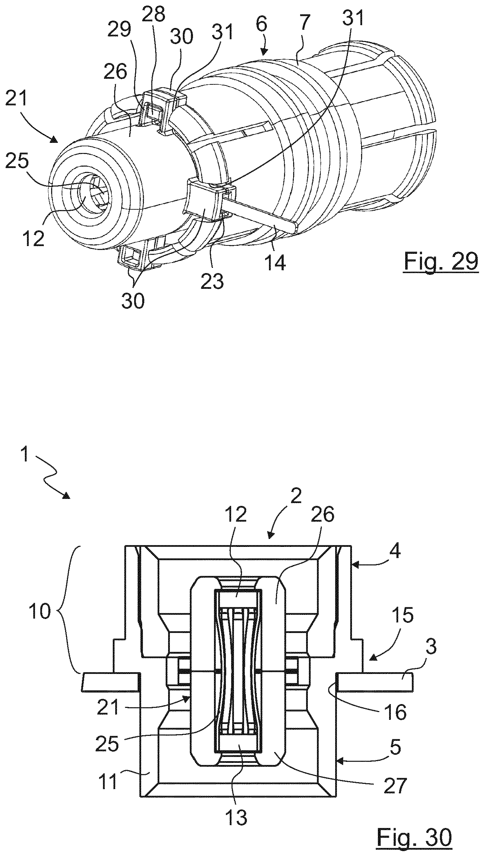

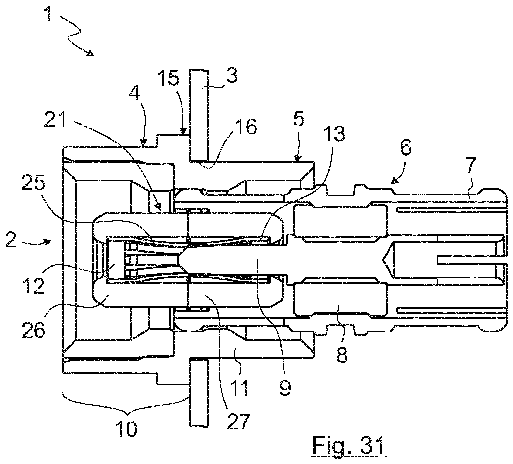

Ein sechstes Ausführungsbeispiel der erfindungsgemäßen Leiterplattenanordnung 1 ist in den Figuren 25 bis 31 dargestellt. Figur 25 zeigt die Leiterplattenanordnung 1 in einer perspektivischen Darstellung, wobei eine perspektivische Explosionsdarstellung in Figur 26 gezeigt ist. Figur 30 zeigt eine Schnittdarstellung der Leiterplattenanordnung 1. Der elektrische Steckverbinder 2 ist in seinem mit dem Gegensteckverbinder 6 verbundenen Zustand ferner in einer Schnittdarstellung in Figur 31 gezeigt.

In dem sechsten Ausführungsbeispiel des elektrischen Steckverbinders 2 ist wiederum ein Innenleiterkontaktelementpaar vorgesehen, das einen buchsenartigen Aufbau aufweist. Das Isolierelement 21 ist zweiteilig aus zwei Isolierteilen 26, 27 ausgebildet. Auch in dem sechsten Ausführungsbeispiel des elektrischen Steckverbinders 2 ist ein zweiteiliger Aufbau des Außenleiterkontaktelementpaares vorgesehen. Dieses kann allerdings ausgehend von derselben Montagerichtung montierbar sein, wobei vor der Montage der beiden Teile des Außenleiterkontaktelementpaares das mit dem Innenleiterkontaktelementpaar bestückte Isolierelement 21 in das Außenleiterkontaktelementpaar eingefügt werden sollte.

Eine Besonderheit des sechsten Ausführungsbeispiels stellt das Isolierelement 21 dar. Ausgehend von dem Außenmantel des Isolierelements 21 erstrecken sich mehrere Stege 30. Beispielhaft sind genau vier Stege 30 vorgesehen, die äquidistant auf dem Außenmantel verteilt angeordnet sind.

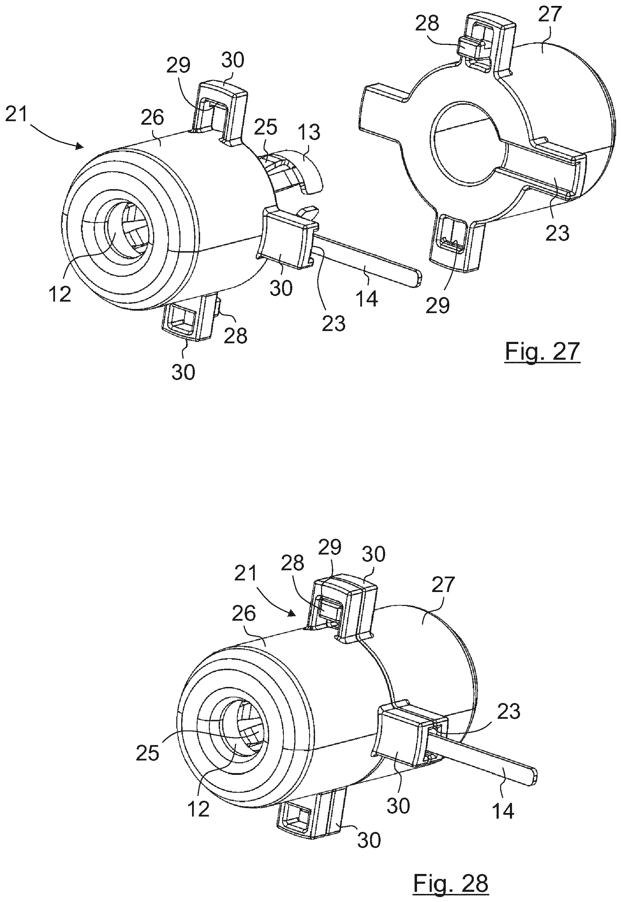

Die Figuren 27 und 28 zeigen das Isolierelement 21 während der Montage in einer vergrößerten Einzeldarstellung zusammen mit dem Innenleiterkontaktelementpaar.

Zur Verbindung der beiden Isolierteile 26, 27 sind wiederum Rasthaken 28 und Rastaufnahmen 29 vorgesehen, die vorliegend an bzw. in den Stegen 30 ausgebildet sind. Beispielhaft weist jedes Isolierteil 26, 27 genau einen Rasthaken 28 und eine Rastaufnahme 29 auf. Grundsätzlich können allerdings beliebig viele Rasthaken 28 und Rastaufnahmen 29 vorgesehen und beliebig verteilt angeordnet sein.

Die Stege 30 ermöglichen eine verdrehsichere Fixierung des Gegensteckverbinders 6 in dessen gestecktem Zustand. Der Gegensteckverbinder 6 kann hierzu entsprechende Aufnahmeabschnitte 31 für die Stege 30 aufweisen. Figur 29 verdeutlicht das Prinzip.

Der Steckverbinder 2 des sechsten Ausführungsbeispiels ist beispielhaft ausgebildet, um ein Einstecken eines Gegensteckverbinders 6 ausschließlich von einer Seite der Leiterplatte 3 zu ermöglichen bzw. um ein gleichzeitiges Einstecken von zwei Gegensteckverbindern 6 zu blockieren. Der elektrische Steckverbinder 2 bzw. die Kontaktelementpaare und das Isolierelement 21 sind dementsprechend ausgebildet, dass der Gegensteckverbinder 6 in seinem vollständig gesteckten Zustand über den mittleren Bereich des elektrischen Steckverbinders 2 hinaus- und damit in die gegenüberliegende Schnittstelle 4 hineinragt, wie sich besonders gut anhand der Figuren 29 und 31 ergibt. Ein weiterer Gegensteckverbinder 6 kann sich somit ausgehend von der gegenüberliegenden Seite der Leiterplatte 3 zumindest nicht vollständig bzw. ausreichend tief in den elektrischen Steckverbinder 2 einstecken lassen.

## Patentansprüche

1. Elektrischer Steckverbinder (2) mit einem ersten Endabschnitt, an dem eine erste Schnittstelle (4) angeordnet ist und mit einem zweiten Endabschnitt, an dem eine zweite Schnittstelle (5) angeordnet ist, wobei die erste Schnittstelle (4) und die zweite Schnittstelle (5) jeweils mit einem elektrischen Gegensteckverbinder (6) verbindbar sind, und wobei die erste Schnittstelle (4) mit der zweiten Schnittstelle (5) wenigstens zwei Kontaktelementpaare ausbildet, wobei jedes der Kontaktelementpaare ein erstes Kontaktelement (10, 12) aufweist, das der ersten Schnittstelle (4) zugeordnet ist und ein mit dem ersten Kontaktelement (10, 12) mechanisch verbundenes zweites Kontaktelement (11, 13) aufweist, das der zweiten Schnittstelle (5) zugeordnet ist, und wobei zwischen dem ersten Endabschnitt und dem zweite Endabschnitt eine dritte Schnittstelle (15) vorgesehen ist, um zumindest eines der Kontaktelementpaare elektrisch und mechanisch mit einer elektrischen Leiterplatte (3) zu verbinden, **dadurch gekennzeichnet, dass** die dritte Schnittstelle eine nicht-koaxiale Schnittstelle ist und dass der Steckverbinder ausgebildet ist, um in eine Ausnehmung (16) innerhalb der Leiterplatte (3) aufgenommen zu werden.

2. Elektrischer Steckverbinder (2) nach Anspruch 1,
**gekennzeichnet durch**
einen linearen Verlauf zwischen dem ersten Endabschnitt und dem zweiten Endabschnitt.

3. Elektrischer Steckverbinder (2) nach Anspruch 1 oder 2,
**dadurch gekennzeichnet, dass**
die erste Schnittstelle (4) und die zweite Schnittstelle (5) jeweils mit einem elektrischen Gegensteckverbinder (6) identischen Steckverbindertyps verbindbar sind.

4. Elektrischer Steckverbinder (2) nach einem der Ansprüche 1 bis 3,
**dadurch gekennzeichnet, dass**
eines der Kontaktelementpaare als Außenleiterkontaktelementpaar mit einem ersten Außenleiterkontaktelement (10) und mit einem zweiten Außenleiterkontaktelement (11) und die weiteren der Kontaktelementpaare als Innenleiterkontaktelementpaare mit einem jeweiligen ersten Innenleiterkontaktelement (12) und mit einem jeweiligen zweiten Innenleiterkontaktelement (13) ausgebildet sind.

5. Elektrischer Steckverbinder (2) nach Anspruch 4,
**dadurch gekennzeichnet, dass**
die Längsachsen der beiden Außenleiterkontaktelemente (10, 11) des Außenleiterkontaktelementpaares koaxial verlaufen und die Längsachsen der Innenleiterkontaktelemente (12, 13) eines jeweiligen Innenleiterkontaktelementpaares koaxial verlaufen.

6. Elektrischer Steckverbinder (2) nach Anspruch 4 oder 5,
**dadurch gekennzeichnet, dass**
genau ein Innenleiterkontaktelementpaar koaxial innerhalb des Außenleiterkontaktelementpaares angeordnet ist.

7. Elektrischer Steckverbinder (2) nach einem der Ansprüche 4 bis 6,
**dadurch gekennzeichnet, dass**
die Innenleiterkontaktelemente (12, 13) als Stiftkontakte oder als Buchsenkontakte ausgebildet sind.

8. Elektrischer Steckverbinder (2) nach einem der Ansprüche 1 bis 7,
**dadurch gekennzeichnet, dass**
die beiden Kontaktelemente (10, 12, 11, 13) eines gemeinsamen Kontaktelementpaares einteilig oder zweiteilig ausgebildet sind.

9. Elektrischer Steckverbinder (2) nach einem der Ansprüche 1 bis 8,
**dadurch gekennzeichnet, dass**
die dritte Schnittstelle (15) zur Verbindung des zumindest einen Kontaktelementpaares mit der elektrischen Leiterplatte (3) zumindest ein Kontaktierungsmittel (14) pro Kontaktelementpaar aufweist, das sich vorzugsweise ausgehend von dem jeweiligen Kontaktelementpaar von der Längsachse des Steckverbinders (2) weg erstreckt.

10. Elektrischer Steckverbinder (2) nach Anspruch 9,
**dadurch gekennzeichnet, dass**
das zumindest eine Kontaktierungsmittel
a) als Kontaktkörper (14) ausgebildet ist, der sich in radialer Richtung ausgehend von zumindest einem der Kontaktelemente (10, 12, 11, 13) eines gemeinsamen Kontaktelementpaares erstreckt; und/oder
b) als Lötfläche ausgebildet ist, die an zumindest einem der Kontaktelemente (10, 12, 11, 13) eines gemeinsamen Kontaktelementpaares ausgebildet ist; und/oder
c) als Kontaktfuß ausgebildet ist, der an zumindest einem der Kontaktelemente (10, 12, 11, 13) eines gemeinsamen Kontaktelementpaares ausgebildet ist.

11. Elektrischer Steckverbinder (2) nach einem der Ansprüche 1 bis 10,
**gekennzeichnet durch**
ein die Kontaktelementpaare elektrisch voneinander isolierendes Isolierelement (21), das zwischen der ersten Schnittstelle (4) und der zweiten Schnittstelle (5) angeordnet ist, wobei das Isolierelement (21) vorzugsweise zweiteilig ausgebildet ist.

12. Elektrischer Steckverbinder (2) nach Anspruch 11,
**dadurch gekennzeichnet, dass**
das Isolierelement (21) einen ringförmig umlaufenden Außenmantel aufweist, ausgehend von dem sich mehrere Stege (30) erstrecken, vorzugsweise drei oder mehr äquidistant auf dem Außenmantel verteilt angeordnete Stege (30), besonders bevorzugt vier oder mehr äquidistant auf dem Außenmantel verteilt angeordnete Stege (30).

13. Elektrischer Steckverbinder (2) nach Anspruch 11 oder 12,
**dadurch gekennzeichnet, dass**
das Isolierelement (21) einen stirnseitigen Anschlag (24) für den Gegensteckverbinder (6) ausbildet.

14. Leiterplattenanordnung (1), aufweisend einen elektrischen Steckverbinder (2) nach einem der Ansprüche 1 bis 13 und die elektrische Leiterplatte (3), wobei der Steckverbinder (2) in einer Ausnehmung (16) innerhalb der Leiterplatte (3) aufgenommen und über die dritte Schnittstelle (15) mit wenigstens einer elektrischen Leitung (17) der Leiterplatte (3) verbunden ist.

15. Verfahren zur Montage einer Leiterplattenanordnung (1), wonach ein elektrischer Steckverbinder (2), aufweisend einen ersten Endabschnitt, an dem eine erste Schnittstelle (4) angeordnet ist und einen zweiten Endabschnitt, an dem eine zweite Schnittstelle (5) angeordnet ist, durch eine Ausnehmung (16) in einer elektrischen Leiterplatte (3) hindurchgeführt und an der Leiterplatte (3) befestigt wird, wobei die erste Schnittstelle (4) mit der zweiten Schnittstelle (5) wenigstens zwei Kontaktelementpaare ausbildet, wobei jedes der Kontaktelementpaare ein erstes Kontaktelement (10, 12) aufweist, das der ersten Schnittstelle (4) zugeordnet ist und ein mit dem ersten Kontaktelement (10, 12) mechanisch verbundenes zweites Kontaktelement (11, 13) aufweist, das der zweiten Schnittstelle (5) zugeordnet ist, und wobei zwischen dem ersten Endabschnitt und dem zweiten Endabschnitt eine nicht-koaxiale, dritte Schnittstelle (15) vorgesehen ist, über die zumindest eines der Kontaktelementpaare elektrisch und mechanisch mit der Leiterplatte (3) verbunden wird.

## Claims

1. Electrical connector (2) having a first end portion, on which a first interface (4) is arranged, and having a second end portion, on which a second interface (5) is arranged, wherein the first interface (4) and the second interface (5) can each be connected to an electrical mating connector (6), and wherein the first interface (4) forms at least two contact element pairs with the second interface (5), wherein each of the contact element pairs has a first contact element (10, 12), which is associated with the first interface (4), and a second contact element (11, 13), which is mechanically connected to the first contact element (10, 12) and is associated with the second interface (5), and wherein a third interface (15) is provided between the first end portion and the second end portion in order to electrically and mechanically connect at least one of the contact element pairs to an electric printed circuit board (3), **characterized in that** the third interface is a non-coaxial interface and that the connector is designed for being received in an opening (16) within the printed circuit board (3).

2. Electrical connector (2) according to Claim 1,
**characterized by**
a linear extent between the first end portion and the second end portion.

3. Electrical connector (2) according to Claim 1 or 2,
**characterized in that**
the first interface (4) and the second interface (5) can each be connected to an electrical mating connector (6) of an identical connector type.

4. Electrical connector (2) according to one of Claims 1 to 3,
**characterized in that**
one of the contact element pairs is designed as an outer conductor contact element pair having a first outer conductor contact element (10) and having a second outer conductor contact element (11), and the further contact element pairs are designed as inner conductor contact element pairs having a respective first inner conductor contact element (12) and having a respective second inner conductor contact element (13).

5. Electrical connector (2) according to Claim 4,
**characterized in that**
the longitudinal axes of the two outer conductor contact elements (10, 11) of the outer conductor contact element pair extend coaxially and the longitudinal axes of the inner conductor contact elements (12, 13) of a respective inner conductor contact element pair extend coaxially.

6. Electrical connector (2) according to Claim 4 or 5,
**characterized in that**
precisely one inner conductor contact element pair is arranged coaxially within the outer conductor contact element pair.

7. Electrical connector (2) according to one of Claims 4 to 6, **characterized in that**
the inner conductor contact elements (12, 13) are designed as pin contacts or as socket contacts.

8. Electrical connector (2) according to one of Claims 1 to 7, **characterized in that**
the two contact elements (10, 12, 11, 13) of a common contact element pair are formed in one part or in two parts.

9. Electrical connector (2) according to one of Claims 1 to 8, **characterized in that**
the third interface (15) for connecting the at least one contact element pair to the electric printed circuit board (3) has at least one contacting means (14) for each contact element pair, which preferably extends away from the longitudinal axis of the connector (2), starting from the respective contact element pair.

10. Electrical connector (2) according to Claim 9,
**characterized in that**
the at least one contacting means
a) is designed as a contact body (14), which extends in the radial direction starting from at least one of the contact elements (10, 12, 11, 13) of a common contact element pair; and/or
b) is designed as a solder surface, which is formed on at least one of the contact elements (10, 12, 11, 13) of a common contact element pair; and/or
c) is designed as a contact foot, which is formed on at least one of the contact elements (10, 12, 11, 13) of a common contact element pair.

11. Electrical connector (2) according to one of Claims 1 to 10,
**characterized by**
an insulating element (21), which electrically insulates the contact element pairs from one another and is arranged between the first interface (4) and the second interface (5), wherein the insulating element (21) is preferably formed in two parts.

12. Electrical connector (2) according to Claim 11,
**characterized in that**
the insulating element (21) has an annularly circumferential outer sheath from which multiple webs (30) extend, preferably three or more webs (30) arranged equidistantly distributed on the outer sheath, particularly preferably four or more webs (30) arranged equidistantly distributed on the outer sheath.

13. Electrical connector (2) according to Claim 11 or 12,
**characterized in that**
the insulating element (21) forms an end-face stop (24) for the mating connector (6).

14. Printed circuit board arrangement (1), having an electrical connector (2) according to one of Claims 1 to 13 and the electric printed circuit board (3), wherein the connector (2) is received in an opening (16) within the printed circuit board (3) and is connected to at least one electric line (17) of the printed circuit board (3) via the third interface (15).

15. Method for assembling a printed circuit board arrangement (1), according to which an electrical connector (2) having a first end portion, on which a first interface (4) is arranged, and a second end portion, on which a second interface (5) is arranged, is guided through an opening (16) in an electric printed circuit board (3) and attached to the printed circuit board (3), wherein the first interface (4) forms at least two contact element pairs with the second interface (5), wherein each of the contact element pairs has a first contact element (10, 12), which is associated with the first interface (4), and a second contact element (11, 13), which is mechanically connected to the first contact element (10, 12) and is associated with the second interface (5), and wherein a non-coaxial third interface (15) is provided between the first end portion and the second end portion, via which at least one of the contact element pairs is electrically and mechanically connected to the printed circuit board (3).

## Revendications

1. Connecteur électrique (2) avec une première section terminale, sur laquelle est disposée une première interface (4) et avec une deuxième section terminale, sur laquelle est disposée une deuxième interface (5), dans lequel la première interface (4) et la deuxième interface (5) peuvent être connectées chacune à un connecteur antagoniste (6) électrique, et dans lequel la première interface (4) forme avec la deuxième interface (5) au moins deux paires d'éléments de contact, dans lequel chacune des paires d'éléments de contact présente un premier élément de contact (10, 12), qui est associé à la première interface (4), et présente un deuxième élément de contact (11, 13), qui est connecté mécaniquement au premier élément de contact (10, 12), qui est associé à la deuxième interface (5), et dans lequel une troisième interface (15) est prévue entre la première section terminale et la deuxième section terminale afin de connecter électriquement et mécaniquement au moins une des paires d'éléments de contact à un circuit imprimé électrique (3), **caractérisé en ce que** la troisième interface est une interface non coaxiale et **en ce que** le connecteur est formé pour être reçu dans un évidement (16) à l'intérieure du circuit imprimé (3).

2. Connecteur électrique (2) selon la revendication 1,
**caractérisé par**
un déroulement linéaire entre la première section terminale et la deuxième section terminale.

3. Connecteur électrique (2) selon la revendication 1 ou 2,
**caractérisé en ce que**,
la première interface (4) et la deuxième interface (5) peuvent être connectées chacune à un connecteur antagoniste électrique (6) de type de connecteur identique.

4. Connecteur électrique (2) selon l'une des revendications 1 à 3,
**caractérisé en ce que**,
l'une des paires d'éléments de contact est formée sous la forme d'une paire d'éléments de contact du conducteur externe avec un premier élément de contact du conducteur externe (10) et avec un deuxième élément de contact du conducteur externe (11) et les autres des paires d'éléments de contact sont formées sous la forme de paires d'éléments de contact du conducteur interne avec un premier élément de contact du conducteur interne (12) respectif et avec un deuxième élément de contact du conducteur interne (13) respectif.

5. Connecteur électrique (2) selon la revendication 4,
**caractérisé en ce que**,
les axes longitudinaux des deux éléments de contact du conducteur externe (10, 11) de la paire d'éléments de contact du conducteur externe s'étendent de façon coaxiale et les axes longitudinaux des éléments de contact du conducteur interne (12, 13) d'une paire d'éléments de contact du conducteur interne respective s'étendent de façon coaxiale.

6. Connecteur électrique (2) selon la revendication 4 ou 5,
**caractérisé en ce que**,
exactement une paire d'éléments de contact du conducteur interne est disposée de façon coaxiale à l'intérieur de la paire d'éléments de contact du conducteur externe.

7. Connecteur électrique (2) selon l'une des revendications 4 à 6,
**caractérisé en ce que**,
les éléments de contact du conducteur interne (12, 13) sont formés sous forme de contacts à broche ou de contacts femelles.

8. Connecteur électrique (2) selon l'une des revendications 1 à 7,
**caractérisé en ce que**,
les deux éléments de contact (10, 12, 11, 13) d'une paire d'éléments de contact commune sont formés en une pièce ou en deux pièces.

9. Connecteur électrique (2) selon l'une des revendications 1 à 8,
**caractérisé en ce que**,
la troisième interface (15) pour la connexion de ladite au moins une paire d'éléments de contact avec le circuit imprimé électrique (3) présente au moins un moyen de contact (14) par paire d'éléments de contact, qui s'étend de préférence à l'écart de l'axe longitudinal du connecteur (2) à partir de la paire d'éléments de contact respective.

10. Connecteur électrique (2) selon la revendication 9,
**caractérisé en ce que**,
ledit au moins un moyen de contact
a) est formé comme un corps de contact (14), qui s'étend dans la direction radiale à partir d'au moins un des éléments de contact (10, 12, 11, 13) d'une paire d'éléments de contact commune ; et/ou
b) est formé comme une surface de brasage, qui est formée sur au moins un des éléments de contact (10, 12, 11, 13) d'une paire d'éléments de contact commune ; et/ou
c) est formé comme un pied de contact, qui est formé sur au moins un des éléments de contact (10, 12, 11, 13) d'une paire d'éléments de contact commune.

11. Connecteur électrique (2) selon l'une des revendications 1 à 10,
**caractérisé par**
un élément isolant (21), qui isole électriquement les paires d'éléments de contact l'une de l'autre, qui est disposé entre la première interface (4) et la deuxième interface (5), dans lequel l'élément isolant (21) est formé préférablement en deux pièces.

12. Connecteur électrique (2) selon la revendication 11,
**caractérisé en ce que**,
l'élément isolant (21) présente une enveloppe extérieure circonférentielle annulaire, à partir de laquelle s'étendent plusieurs entretoises (30), préférablement trois entretoises (30) ou plus réparties de manière équidistante sur l'enveloppe extérieure, de manière particulièrement préférée quatre entretoises (30) ou plus réparties de manière équidistante sur l'enveloppe extérieure.

13. Connecteur électrique (2) selon la revendication 11 ou 12,
**caractérisé en ce que**,
l'élément isolant (21) forme une butée frontale (24) pour le connecteur antagoniste (6).

14. Assemblage de circuit imprimé (1) comprenant un connecteur électrique (2) selon l'une des revendications 1 à 13 et le circuit imprimé électrique (3), dans lequel le connecteur (2) est reçu dans un évidement (16) à l'intérieur du circuit imprimé (3) et est connecté à au moins une ligne électrique (17) du circuit imprimé (3) via la troisième interface (15).

15. Procédé de montage d'un assemblage d'un circuit imprimé (1), selon lequel un connecteur électrique (2), présentant une première section terminale, sur laquelle est disposée une première interface (4), et une deuxième section terminale, sur laquelle est disposée une deuxième interface (5), est passé à travers un évidement (16) dans un circuit imprimé électrique (3) et est fixé au circuit imprimé (3), dans lequel la première interface (4) forme avec la deuxième interface (5) au moins deux paires d'éléments de contact, dans lequel chacune des paires d'éléments de contact présente un premier élément de contact (10, 12), qui est associé à la première interface (4), et un deuxième élément de contact (11, 13), qui est connecté mécaniquement au premier élément de contact (10, 12), qui est associé à la deuxième interface (5), et dans lequel une troisième interface (15) non coaxiale est prévue entre la première section terminale et la deuxième section terminale, par l'intermédiaire de laquelle au moins une des paires d'éléments de contact est connectée électriquement et mécaniquement au circuit imprimé (3).
